Europäisches Patentamt

European Patent Office

Office européen des brevets

(11) Publication number: **0 167 157 B1**

## EUROPEAN PATENT SPECIFICATION

(45) Date of publication of patent specification: **25.03.92**   (51) Int. Cl.5: **H03K 5/13, H03K 7/08**

(21) Application number: **85108223.0**

(22) Date of filing: **04.07.85**

(54) **Delay circuit.**

(30) Priority: **05.07.84 US 628063**
**05.07.84 US 628069**

(43) Date of publication of application:
**08.01.86 Bulletin 86/02**

(45) Publication of the grant of the patent:
**25.03.92 Bulletin 92/13**

(84) Designated Contracting States:
**DE FR GB**

(56) References cited:
EP-A- 0 059 802    FR-A- 2 285 750
US-A- 3 356 989    US-A- 3 760 280
US-A- 3 828 279    US-A- 4 099 204
US-A- 4 119 938    US-A- 4 127 034
US-A- 4 413 332

IEE PROCEEDINGS SECTION B, vol. 128, part B, no. 5, September 1981, pages 243-248, Old Wokin, Surrey, GB; D.A. GRANT et al.: "Ratio changing in pulse-width-modulated inverters"

(73) Proprietor: **Hewlett-Packard Company**
**Mail Stop 20 B-O, 3000 Hanover Street**
**Palo Alto, California 94304(US)**

(72) Inventor: **Baumgartner, Richard A.**
**440 Mario Ave.**
**Palo Alto California 94301(US)**
Inventor: **Dukes, John N.**
**22783 Lupine Rd.**
**Los Altos Hills California 94022(US)**
Inventor: **Fisher, George A.**
**2 Harding Street**
**Andover Massachusetts 01810(US)**
Inventor: **Bennett, Ian**
**635 Georgia Ave.**
**Palo Alto California 94306(US)**
Inventor: **Pering, Richard D.**
**243 Rinconada Ave.**
**Palo Alto California 94301(US)**

(74) Representative: **KOHLER SCHMID + PARTNER**
**Patentanwälte**
**Ruppmannstrasse 27**
**W-7000 Stuttgart 80(DE)**

Rank Xerox (UK) Business Services

TELECOMMUNICATIONS AND RADIO ENGI-
NEERING, no. 12, December 1967, pages
76-79, Washington, US; V.V. MALANOV:
"Application and realization of two-cycle
two-sided pulse-width modulation of the
second skin"

IBM TECHNICAL DISCLOSURE BULLETIN, vol.
12, no. 7, December 1969, pages 1127-1128,
New York, US; L.P. WEST: "Propagation delay
modulation"

ULTRASONICS SYMPOSIUM PROCEEDINGS,
New Orleans, LA, 26th-28th September 1979,
pages 204-209, IEEE, New York, US; M. FINK
et al.: "Wideband fresnel focusing array re-
sponse"

HEWLETT-PACKARD JOURNAL, October
1983, pages 3-6; H.E. KARRER et al.:
"Ultrasound imaging: An overview

## Description

The invention relates to a delay circuit according to the preamble of claim 1.

Such a delay circuit is known from US-A-4 099 204.

A delay circuit of another kind is known from US-A-3 760 280. In this delay circuit, an analog input signal is converted into a frequency modulated (FM) signal which in turn is delayed by means of a clocked digital shift register. The delayed signal is then demodulated to provide a delayed analog output signal.

The known delay circuit has the disadvantage that it reduces the bandwidth of the analog signal to be delayed. Although the bandwidth could theoretically be increased by increasing the clock frequency of the shift register, the bandwidth is limited in that for higher clock frequencies the expenditure of circuitry becomes very high and in that undesired high-frequency spurious emissions occur. For example, for the delayed output signal to have a 5 MHz information bandwidth with a resolution of 0,1 %, the shift register would have to be clocked with a frequency at or above 10 GHz, thus causing disturbing high-frequency emissions.

The delay circuit known from the US-A-4 099 204 comprises a fixed number of inverter stages, each delaying a FM-modulated input signal by an incremental delay amount. Taps are provided at each incremental delay stage, wherein a tap control logic controls a switching circuit for deriving from the delay circuit a delayed output signal having a variable delay which is determined by the tap control logic. The delayed time of the known delay circuit can be adjusted by varying the supply voltage; the known delay circuit includes a sync separator which separates a certain synchronisation sequence from the delayed pulses and an error detector which compares the separated synchronisation sequence with a reference synchronisation signal. An error signal which results from the comparison is used for adjustment of the delay amount of the delay circuit. (Figures 10 and 11 of this document).

The EP-A-0 059 802 describes a further known delay circuit for delaying pulses which are derived from horizontal synchronising pulses of a colour television set. The delay circuit comprises cascaded inverter stages, each of which includes a field effect transistor for providing a resistance to current flow and field effect transfer transistors. For the adjustment of the delayed time of the whole inverter chain, an odd number of stages of the inverted chain are coupled into a ring counter circuit which thereby creates a self-oscillation, the frequency of which is depending on the delay time of each inverter. By means of counting the frequency of the self-oscillation signal it is possible to determine the actual delay time, whereby the adjustable resistance elements are adjusted so, that the actual delay time is matching with a reference delay time. In specific applications, such as in ultrasound acoustic imaging systems which are preferred in the present invention, the known delay circuit has disadvantageous effects in that the adjustment operation cannot be carried out during the normal operating time, because the delay circuit must be switched into the ring counter configuration which is carried out during the fly-back period of the television apparatus. Furtheron, as the primary condition for generating self-oscillation, a certain odd number of inverter stages has to be coupled together into the ring circuit, thereby leaving at least one delay circuit which cannot be adjusted. Furtheron, for the adjustment of the delay time of the known delay circuit a very precise clock frequency has to be generated and applied to the frequency counters.

Accordingly it is an object of the invention to improve the delay circuit according to the preamble of claim 1 so that it can be adjusted in its delay time continuously without an interruption, can be implemented with a simple circuit design and provides a great signal bandwidth.

The above object is solved by the features specified in the characterizing part of claim 1. Accordingly, each inverter stage of the delay circuit has a simple circuit construction and allows a continuous adjustment during the normal operation of the delay circuit by comparison of the phase of the input signal to the delay circuit with the phase of its output signal. The dependent claims 2 to 10 specify advantageous developments thereof.

Claims 11 to 14 specify the use of the delay circuit in an ultrasound imaging system. According to these features, the invention permits the design of the circuit which delays a plurality of analog input signals by adjustable different delay times and derives an output signal corresponding to the sum of the delayed signals. The invention allows to sum up pulse width modulated signals prior to being supplied to a demodulator and to supply the sum signal to a common demodulator, so that it is not necessary to have a demodulator for each individual delay circuit.

Subsequently, an embodiment of the invention is explained in detail with reference to the drawings.

Figure 1 is a schematic diagram of cascaded inverters used in an embodiment of the present invention.

Figure 2 shows a circuit which uses a switch to vary propagation time through the circuit.

Figure 3 shows a circuit which varies propagation delay from an input to an output by means of switches organized in the form of a binary tree.

Figure 4 shows a circuit which varies propagation delay by means of an analog signal.

Figures 5A - 5B show the coupling of two inverters to form a delay stage.

Figures 5C - 5E show the coupling of two inverters to form a delay stage used in an embodiment of the present invention.

Figure 6 is a block diagram of an analog signal delay circuit in accordance with a preferred embodiment of the present invention.

Figure 7 shows a typical waveform of a signal at a location on the circuit of Figure 6.

Figure 8 is a block diagram of an analog signal delay circuit utilizing pulse width modulation.

Figures 8A - 8C show alternative designs for pulse width modulators which may be used with the analog signal delay circuit shown in Figure 8.

Figure 8D shows a timing diagram for voltage signals in comparators shown in Figures 8A - 8C.

Figure 9A shows another design for a pulse width modulator.

Figure 9B is a timing diagram of signals from the pulse width modulator shown in Figure 9A.

Figure 9C shows an alternative design for a pulse width modulator.

Figures 9D - 9G are timing diagrams of signals from the pulse width modulator shown in Figure 9C.

Figure 10 is a block diagram of an analog signal delay circuit utilizing frequency modulation.

Figure 11 is a block diagram of an analog signal delay circuit utilizing phase modulation.

Figure 12 shows a block diagram of a circuit which may be used for either frequency modulation or phase modulation.

Figures 13A and 13B are block diagrams of a transversal filter using the delay element according to the invention.

Figure 14 is a block diagram of an acoustic imaging system using the delay circuit according to an embodiment of the invention.

Figure 14A - 14B shows details of delay architecture for the acoustic imaging system of Figure 14.

Figure 15 is a block diagram of an FM detector utilizing the delay element according to an embodiment of the invention.

Figure 15A is a graph showing how an increase in time delay increases the sensitivity of the detector shown in Figure 15.

Figure 16 is a block diagram of an apparatus for calibrating delay time through a delay circuit.

Figure 17 shows a more detailed block diagram of the apparatus of Figure 16 adapted for integration into delay architecture for the acoustic imaging system of Figure 14.

Figure 18 shows an alternative embodiment of a calibration apparatus utilizing a ring oscillator.

Delay of a binary signal may be accomplished by coupling the signal through a series of saturating elements. What is meant by a binary signal is a signal which changes between two voltage levels. The voltage levels, commonly referred to as logic 0 and logic 1 may be, for example, 0 volts and 3 volts.

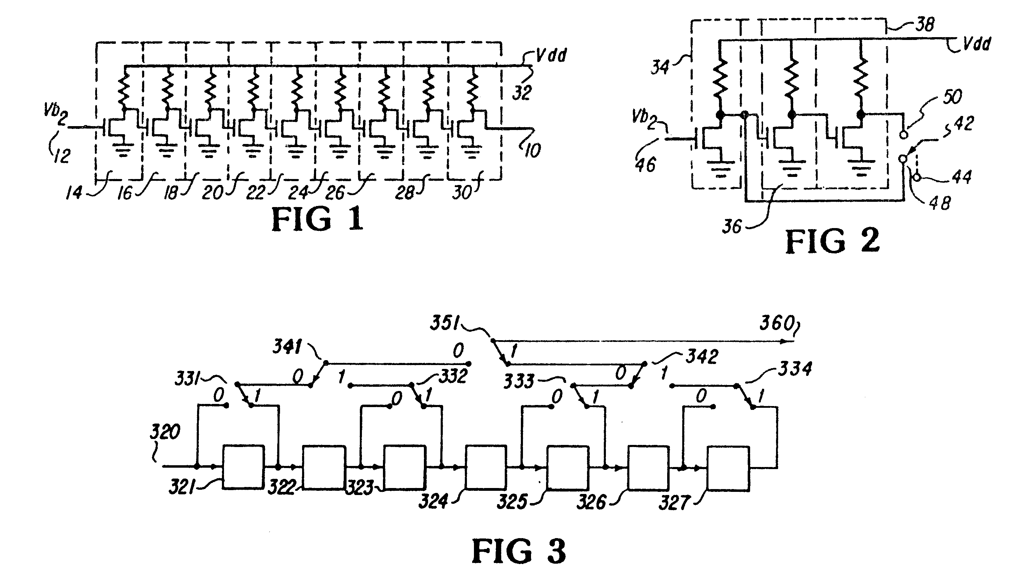

In Figure 1, a binary signal ($Vb_1$) is applied to an input 12 of a plurality of cascaded saturating circuit elements, in this case inverters 14, 16, 18, 20, 22, 24, 26, 28, and 30. A supply voltage (Vdd), for example 3 volts, is coupled to the system at a node 32. In the preferred embodiment, each of the plurality of cascaded inverters has a propagation (or delay) time t of a few (e.g. 3-20) nanoseconds. At an output 10, the delay of the binary signal is equal to the number of inverters multiplied by the propagation time through each inverter. In the circuit of Figure 1, this equals 9t.

In Figure 2, a binary signal ($Vb_2$) is coupled at an input 46 to a plurality of cascaded inverters 34, 36, and 38. An output 42 is coupled to a node 50 or a node 48. A single-pole-double-throw switch 44 or its logic equivalent toggles output 42 between node 50 and node 48, and thus varies the duration of delay from input 46 to output 42. For example, if each of the cascaded inverters has a propagation time t, the delay when output 42 is coupled to node 48 is t and the delay when output 42 is coupled to node 50 is 3t.

In Figure 3, an example is shown of a means to vary delay propagation by digital switching utilizing a binary tree. A binary signal is coupled at an input 320 to a plurality of delay elements 321, 322, 323, 324, 325, 326, and 327, typically groups of cascaded inverters as in Figures 1 and 2. Typically, when fabricated on a single integrated circuit, delay time T will be the same for each delay element group 321-327. A series of logic switches 331, 332, 333, 334, 341, 342, and 351, which are typically single-pole-double-throw switches or their logic equivalent, are arranged in the form of a binary tree to select a propagation time through the entire circuit. Depending upon the position of switches 331-334, 341-342, and 351, the range of propagation delay from input 320 to an output 360 is OT to 7T. In the circuit of Figure 3 there are 3 levels of switches: switch 351 forms the first level; switches 341 and 342 form the second level; and switches 331, 332, 333, and 334 form the third order level. The switches at each level , for convenience, may be switched together. For instance, as shown in Figure 3, third level switches 331, 332, 333, and 334 are each selecting a pole labeled "1".

In the embodiment shown in Figure 3 each level of switches represents a bit in a binary number. Level 1 is the most significant bit, level 2 is the next most significant bit, and level 3 is the least significant bit, e.g., in Figure 3 level 1 switch 351 is set at "1", level 2 switches 341-342 are set at "0", and level 3 switches 331-334 are set at "1", so that the current delay is $101_{base\ 2}$ times T, that is 5T.

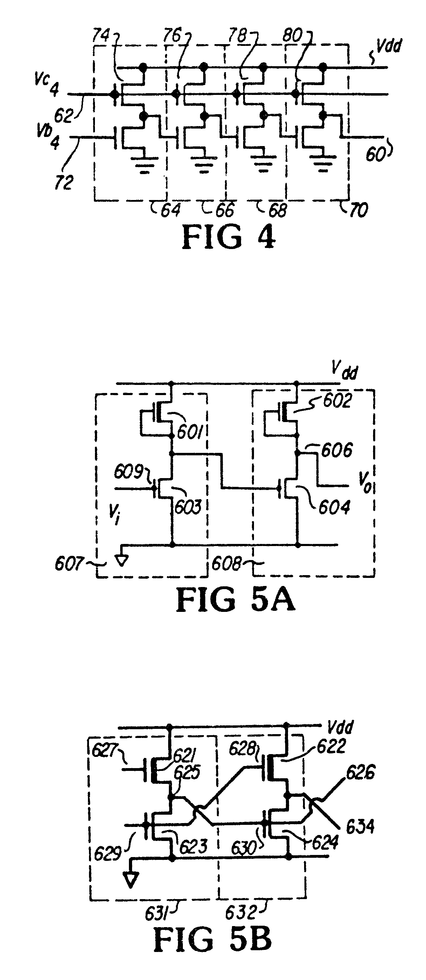

In Figure 4, an alternative method to vary delay is illustrated. A binary signal ($Vb_4$) is coupled at an input 72 to a plurality of saturating elements, 64, 66, 68, and 70, typically cascaded inverters, as shown. Variable resistors 74, 76, 78, and 80, for example depletiontype metal-oxide-silicon field effect transistors (MOSFETS), are controlled by a voltage ($Vc_4$) applied to an input 62 and function as variable current sources. Although delay time t varies as $Vc_4$ varies, typically, when $Vc_4$ is held constant, delay time t will be the same for each saturating element 64, 66, 68, and 70, when saturating elements 64, 66, 68, and 70 are fabricated on a single integrated circuit. Delay from input 72 to output 60, therefore, is always 4t. When $Vc_4$ is decreased, resistance across each of variable resistors 74, 76, 78, and 80 increases, decreasing current through variable resistors 74, 76, 78, and 80 and thereby increasing the propagation (delay) time t of each of the saturating elements 64, 66, 68, and 70. Correspondingly, as $Vc_4$ is decreased, propagation time t decreases. Therefore, varying $Vc_4$ varies the delay from input 72 to output 60.

Figures 5A - 5E illustrate the coupling of two inverters on an integrated circuit. Figure 5A shows a circuit where an inverter 607, comprising an enhancement-type MOSFET 603 and a depletion-type MOSFET 601, is coupled as shown to an inverter 608, comprising an enhancementtype MOSFET 604 and a depletion-type MOSFET 602. MOSFETs 601 and 602 act as load resistances for inverters 607 and 608. An input node 609 is coupled to an output node of a prior inverter. An output node 606 is coupled to an input of a subsequent inverter. As can be seen from Figure 5A, signal Vo on output 606 is the same as a voltage Vi on input 609 after a propagation delay through inverter 607 and a propagation dely through inverter 608. On this circuit experimental results showed a ratio of rise to fall time to be at least 3:1. What is meant by rise time is the time it takes for signal Vo to rise from logic 0 to logic 1 after signal Vo starts to rise from logic 0 to logic 1. What is meant by fall time is the time it takes for signal Vo to fall from logic 1 to logic 0 after signal Vo starts its fall from logic 1 to logic 0. The asymmetry in rise to fall times makes it difficult to propagate high frequency pulse trains through a string of inverters, coupled as in the circuit in Figure 5A, without distortion of the timing between pulses.

In Figure 5B an inverter 631, comprising an enhancement-type MOSFET 623 and a depletion-type MOSFET 621, is coupled as shown to an inverter 632, comprising an enhancement-type MOSFET 624 and a depletion-type MOSFET 622. MOSFETs 621 and 622 act as variable load resistances. An input node 629 and an input node 627 are coupled to output nodes of a prior inverter. An output node 626 and an output node 634 are coupled to inputs of a subsequent inverter. As shown in Figure 5B, input 629 is coupled to MOSFET 623, and is also coupled to a gate 628 of MOSFET 622. Similarly a node 625 of inverter 631 is coupled to MOSFET 624 at a gate 630, and is also coupled to output node 626. The rise to fall ratio from input 629 to output 634 for the circuit of Figure 5B was found to be about 1.5:1. This characteristic makes the circuit in Figure 5B better qualified than the circuit in Figure 5A to propagate high frequency pulse trains.

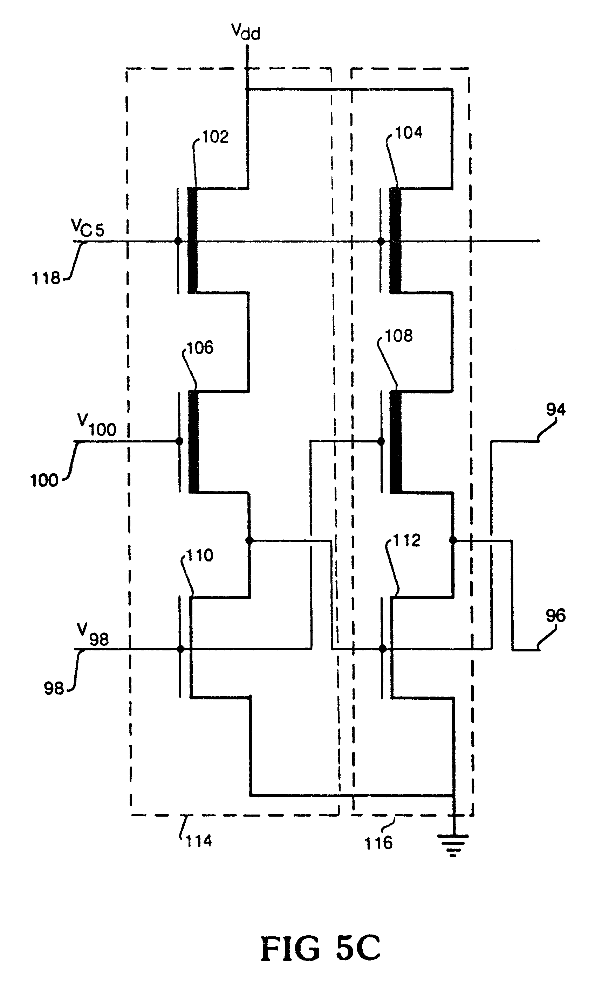

Figure 5C shows a circuit where two inverters, 114 and 116 are coupled. Varying a voltage $Vc_5$ applied to an input 118 varies resistance across a depletion-type MOSFET 102 and a depletion-type MOSFET 104 which both function as variable current sources. An input node 98 and an input node 100 are coupled to outputs nodes of a prior inverter. A voltage $V_{100}$ on input node 100 is an inverse of a voltage $v_{98}$ on input node 98, i.e., when $v_{98}$ is at logic 1, then $V_{100}$ is logic 0, and vice-versa. A depletion-type MOSFET 106 and an enhancement-type MOSFET 110 of inverter 114, are coupled as shown to a depletion-type MOSFET 108 and an enhancement-type MOSFET 112 of inverter 116. An output node 94 and an output node 96 are then available to be coupled to a succeeding inverter.

The major difference between the circuit in Figure 5B and the circuit in Figure 5C is the addition of MOSFETs 102 and 104. These MOSFETs were added in inverters 114 and 116, and similar MOSFETs may be added to every inverter in a series of cascaded inverters, to vary the delay time across each inverter by controlling the current through the inverters. This capacity to vary delay time can be used to standardize propagation time between integrated circuits. Propagation time through integrated circuits may vary because of process variations in the process used to fabricate the integrated circuit. Process variations may include variations in doping density for depletion mode load devices, variations in gate geometries for small geometry devices, and environmental variations, such as variations in temperature.

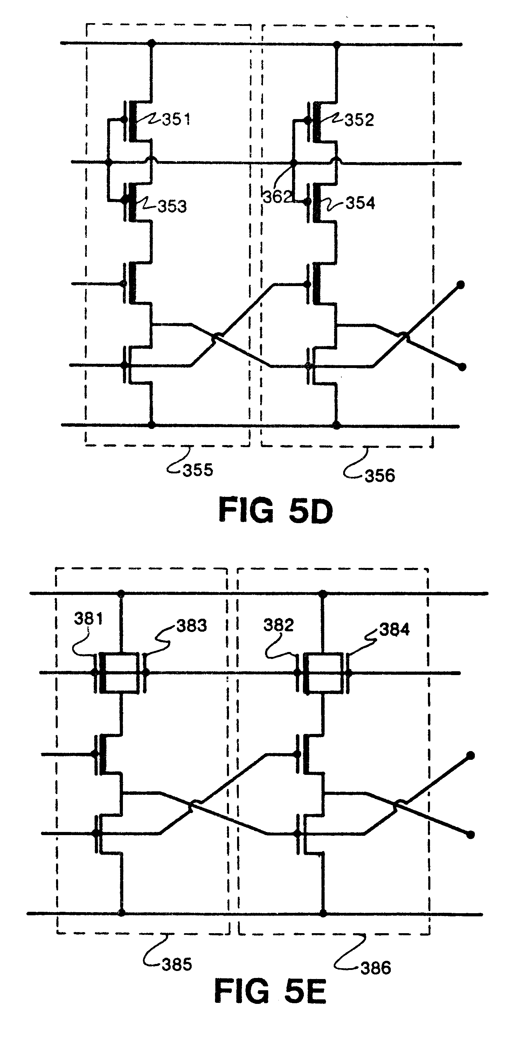

Figures 5D and 5E illustrate alternative embodiments for coupling inverters. These embodiments allow for compensation for for wide variation in propagation time resulting from process variations, without impingement on other inverter performance parameters. In Figure 5D each inverter 355 and 356 has two depletion-type MOSFETS, MOSFETS 351 and 353 in inverter 355, and MOSFETs 352 and 354 in inverter 356, coupled in series to provide time delay variation through current control. In Figure 5E each inverter 385 and 386 has one depletion-type MOSFET and one enhancement-type MOSFET, a depletion-type MOSFET 381 and an enhancement-type MOSFET 383 in inverter 385 and a depletion-type MOSFET 382 and an enhancement-type MOSFET 384 in inverter 386, coupled in parallel to provide time delay variance through current control.

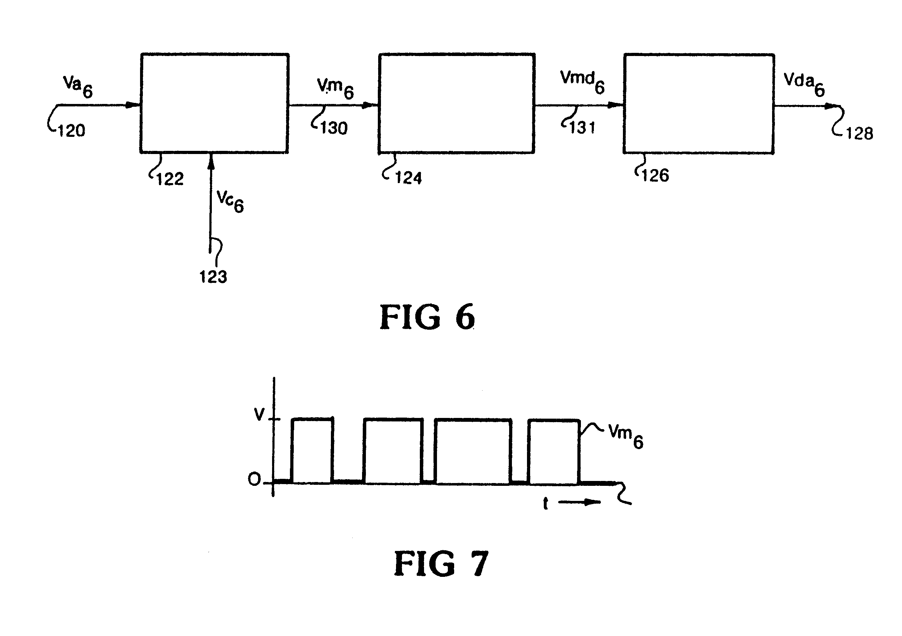

Figure 6 is a block diagram of a circuit for delaying analog signals. An analog input signal $Va_6$ is applied to an input 120. At a modulator 122, signal $Va_6$ modulates a carrier wave $Vc_6$ applied to an input 123. A modulated signal $Vm_6$ from modulator 122 is coupled to an input 130 of a delay circuit 124. Delay circuit 124 consists of a series of saturating elements, for example cascaded inverters as discussed above. A modulated-delayed signal $Vmd_6$ output of delay circuit 124 is coupled at an input 131 to a demodulator 126. A delayed analog signal $Vda_6$ appears on an output node 128. Signal $Vda_6$ is signal $Va_6$ with a delay time determined by delay line 124.

Figure 7 shows, for a pulse width modulated system, an example of a waveform of signal $Vm_6$ at input 130 of delay circuit 124 of the circuit of Figure 6.

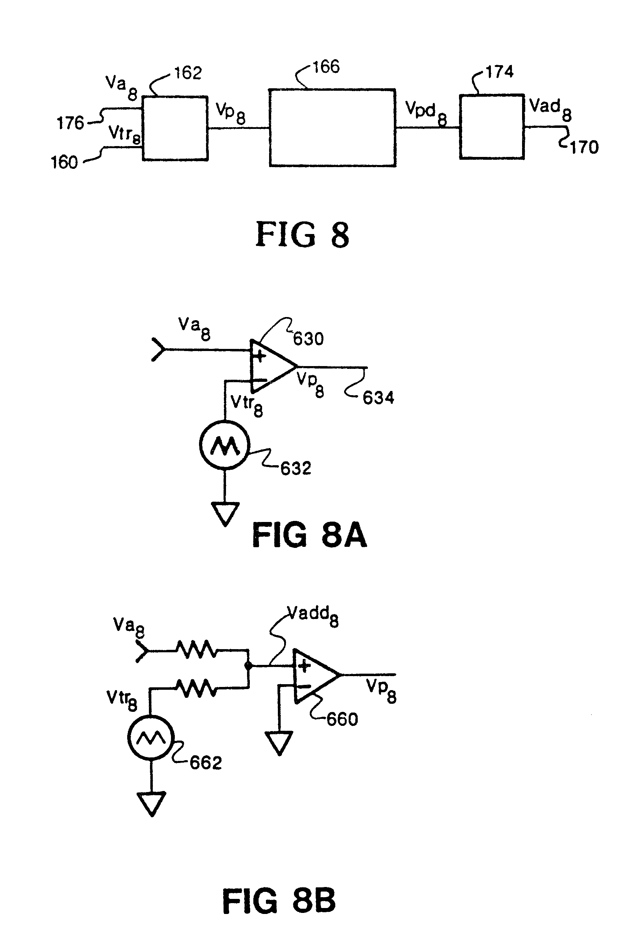

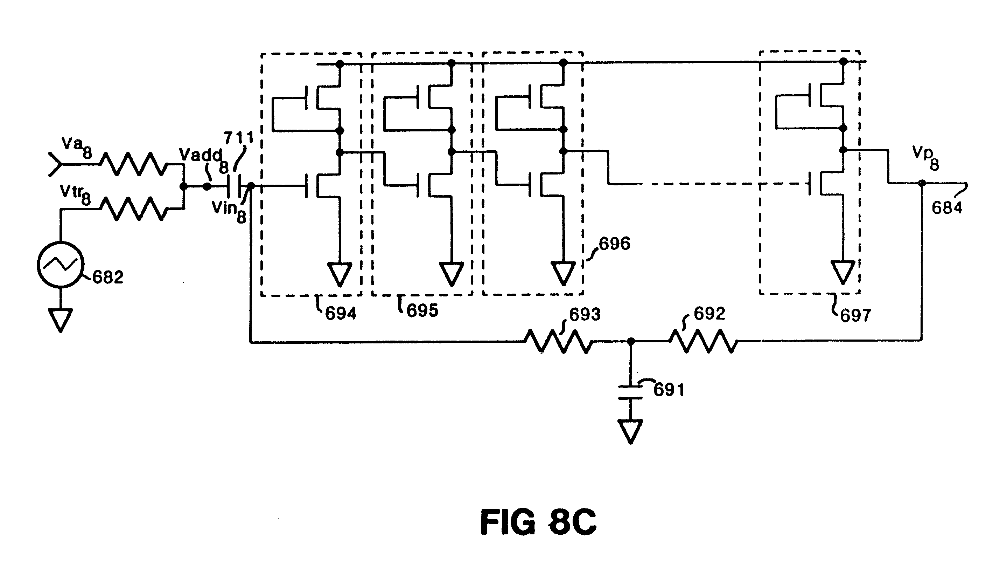

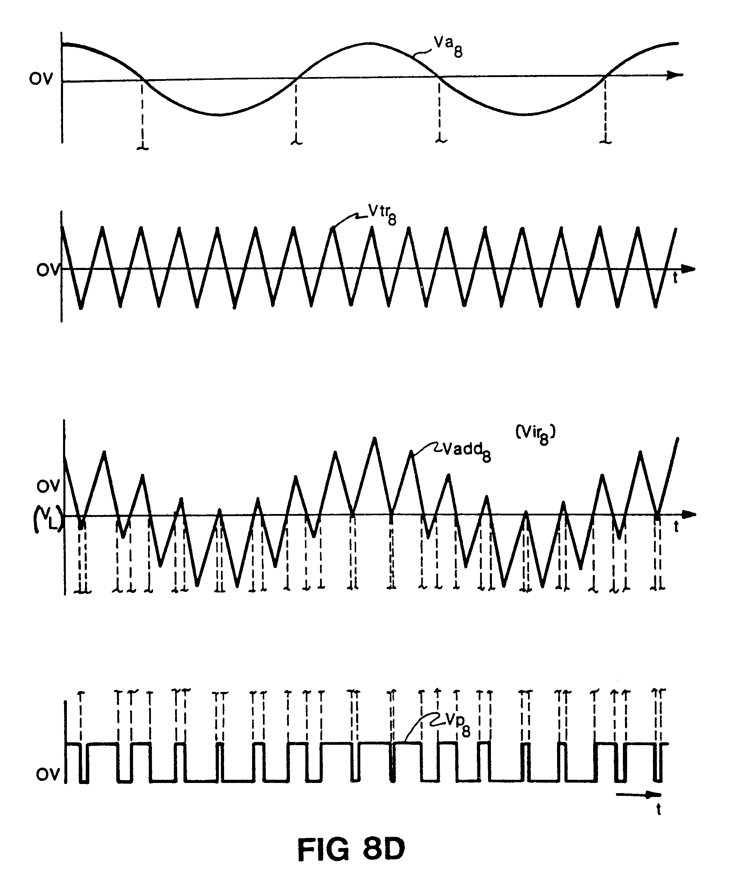

Figure 8 is a simplified block diagram of a delay circuit employing pulse width modulation. An analog signal $Va_8$ is applied to an input 176. A pulse width modulator 162 pulse width modulates analog signal $Va_8$ with a triangle (i.e., a back-to-back sawtooth) wave $Vtr_8$ which is on an input 160. The amplitude of triangle wave $Vtr_8$ must be larger than the maximum amplitude of analog signal $Va_8$, and the frequency of triangle wave $Vtr_8$ must be at least two times the maximum harmonic frequency of interest within analog signal $Va_8$ in order to satisfy the Nyquist sampling theorem.

The output of pulse width modulator 162, a pulse width modulated signal $Vp_8$, is coupled to a delay 166, typically comprising cascaded inverters, as discussed above. A low pass filter 174 converts a delayed pulse width modulated signal $Vpd_8$ which is from delay 166 to a delayed analog signal $Vad_8$. Signal $Vad_8$ appears on a circuit output 170. Signal $Vad_8$ is signal $Va_8$ with a delay time determined by the circuit.

Figures 8A - 8C show alternate designs for pulse width modulator 162 in Figure 8. In the design in Figure 8A, a comparator 630 compares analog signal $Va_8$ with triangle wave $Vtr_8$ generated by a triangle wave generator 632. Pulse width modulated signal $Vp_8$ appears on an output 634 of comparator 630.

In the pulse width modulator of Figure 8B, analog signal $Va_8$ is added to triangle wave $Vtr_8$ generated by a triangle wave generator 662 to form a signal $Vadd_8$. Comparator 660 compares signal $Vadd_8$ with a fixed reference (shown as ground in Figure 8B) to produce pulse width modulated signal $Vp_8$.

In Figure 8C, analog signal $Va_8$ is added to triangle wave $Vtr_8$ generated by a triangle wave generator 682 to form signal $Vadd_8$. Signal $Vadd_8$ is coupled through an input capacitance 711 and becomes an input signal $Vin_8$. Signal $Vin_8$ is propagated through an odd number of cascaded inverters, represented by cascaded inverters 694 to 697, and appears as pulse width modulated signal $Vp_8$ on an output 684. Typically, 21 cascaded inverters would be a sufficient number of inverters for the modulator of Figure 8C.

An input resistance 693, an output resistance 692 and a capacitance 691 serve as a feedback circuit. The feedback circuit constrains the dc component of signal $Vin_8$ to be at the threshold voltage of the first inverter, inverter 694. Therefore, oscillations in signal $Vin_8$ are centered at the threshold voltage of inverter 694. When the dc component of signal $Vin_8$ is below the threshold voltage of inverter 694, then the duty cycle of $Vp_8$ will increase, thus increasing the charge on capacitance 691, and raising the dc component of signal $Vin_8$. Similarly when the dc component of signal $Vin_8$ is above the threshold voltage of inverter 694, then the duty cycle of signal $Vp_8$ will decrease, thus decreasing the charge on capacitance 691 and lowering the dc component of signal $Vin_8$.

Figure 8D is a timing diagram (not drawn to scale) of signals $Va_8$, $Vtr_8$, $Vadd_8$, and $Vp_8$. Signal $Vin_8$ has the same waveform as signal $Vadd_8$ except that the dc component of signal $Vin_8$, represented by a reference signal Vi, is at the threshold voltage of inverter 691, while for the waveforms shown, the dc component of signal $Vadd_8$ is zero volts.

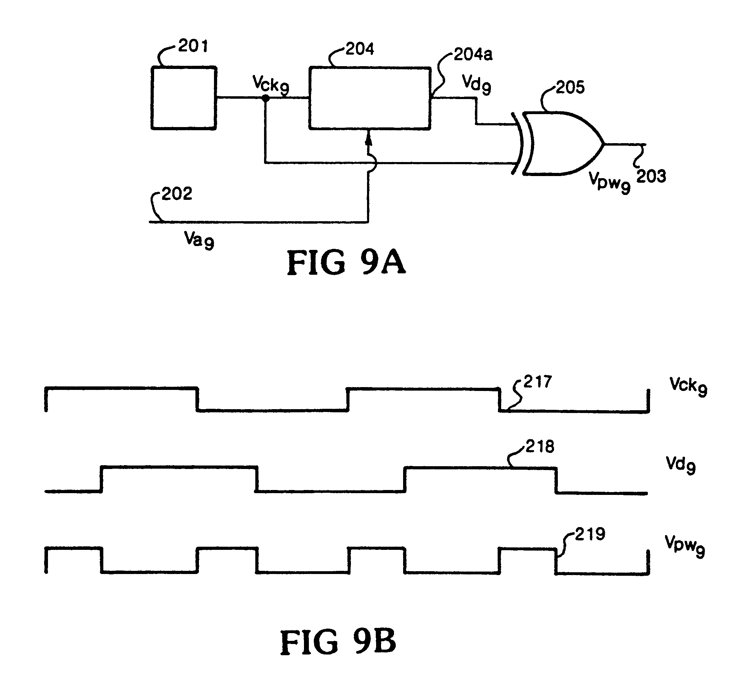

Figure 9A shows another design for a pulse width modulation circuit. A clock generator 201 generates a series of clock pulses $Vck_9$, typically at a frequency of 16 MHz. A Boolean logic gate 205 performs an "Exclusive Or" (XOR) between clock pulses $Vck_9$ proceeding directly from clock generator 201, and a series of pulses $Vd_9$ which have been propagated through a delay 204. Logic gate 205 could be replaced by other logic gates, for instance, an "AND" gate, or an "OR" gate or by various types of "FLIP-FLOPS", which have an output signal with a duty cycle which varies according to the relative phase between two input signals. Typically delay 204 comprises cascaded inverters, as discussed above. An analog signal $Va_9$ is applied to an input 202 of delay 204. Analog signal $Va_9$ varies propagation delay of the clock

pulses $Vck_9$ through delay 204 as explained in the discussion of the circuit in Figure 5C. Typically, when analog signal $Va_9$ is 3.0 volts, delay 204 will perform a 90° phase shift on series of clock pulses $Vd_9$, e.g. a delay of approximately 16 nanoseconds when the clock frequency is 16 MHz.

In Figure 9B, a timing diagram for the circuit in Figure 9A is shown. A waveform 217 represents clock pulses $Vck_9$ generated by clock generator 201. A waveform 218 represents delayed pulses $Vd^9$ at an output 204a of delay 204 after a 90° phase shift. A waveform 219 represents a pulse width modulated signal $Vpw_9$ at an output 203 of logic gate 205. When delay 204 performs a 90° phase shift, pulse width modulated signal $Vpw_9$ is a square wave with a duty cycle of 50% and a frequency equal to twice the frequency of clock pulses $Vck_9$. Increasing the time delay through delay 204 increases the duty cycle of pulse width modulated signal $Vpw_9$. Decreasing the time delay through delay 204 decreases the duty cycle of pulse width modulated signal $Vpw_9$. Thus, analog signal $Va_9$ at input 202 of delay 204 effectively pulse width modulates clock pulses $Vck_9$, by varying the position of the trailing edges of clock pulses $Vck_9$ with respect to the rising edges of clock pulses of clock pulses $Vck_9$.

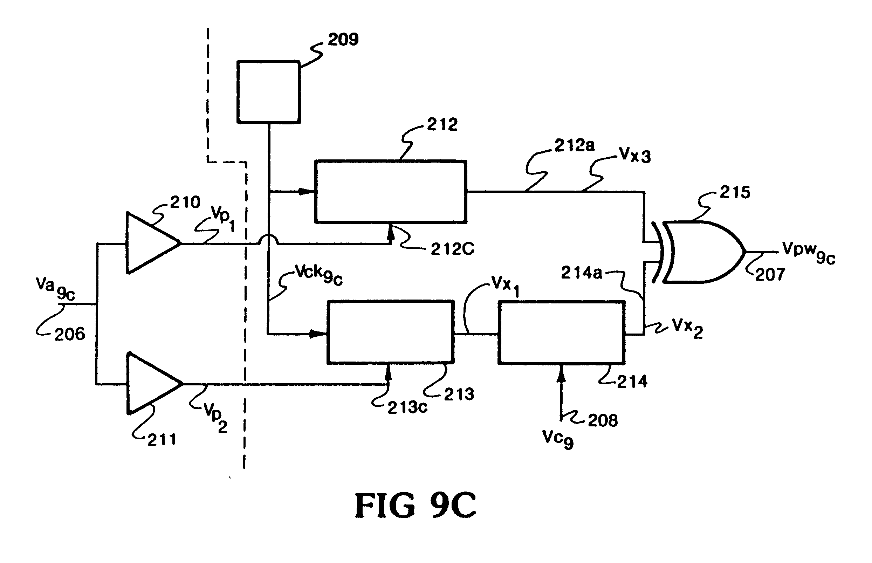

In Figure 9C, another design for a pulse width modulator is shown. A clock generator 209 generates a series of clock pulses $Vck_{9c}$, typically at a frequency of 16 MHz. Clock pulses $Vck_{9c}$ are coupled through a delay 212 and a delay 213. Delays 212 and 213 typically are identical and comprise cascaded inverters, as discussed above. An analog signal $Va_{9c}$ is applied to an input 206 of the circuit. Analog signal $Va_{9c}$ is split into differential voltage drives. For instance, an amplifier 210 inputs analog signal $Va_{9c}$ and outputs a first output signal $Vp_1$ comprising analog signal $Va_{9c}$ summed with a DC bias voltage, while an inverting amplifier 211 inputs analog signal $Va_{9c}$ and outputs a second output signal $Vp_2$ comprising analog signal $Va_{9c}$ inverted and summed with a DC bias voltage.

First output signal $Vp_1$ is coupled to delay 212 at a control input 212c and second output signal $Vp_2$ is coupled to delay 213 at a control input 213c. Output signals $Vp_1$ and $Vp_2$ vary propagation delay of clock pulses $Vck_{9c}$ through delays 212 and 213. A delay 214 provides an additional 90° phase shift on output of delay 213, e.g., a delay of approximately 16 nanoseconds when the clock frequency is 16 MHz. A correction signal $Vc_9$ may be applied to an input 208 of delay 214 to vary propagation through delay 214 for IC process compensation.

A signal $Vx_3$ on an output 212a of delay 212 and a signal $Vx_2$ on an output 214a of delay 214 are coupled through a logic gate 215 to an output 207. Logic gate 215 performs an XOR between the outputs of delays 212 and 214. Logic gate 215 could be replaced by other logic gates, for instance, an "AND" gate, or an "OR" gate or by various types of "FLIP-FLOPS", which have an output signal with a duty cycle which varies according to the relative phase between two input signals. The result of the XOR on output 207 is a pulse width modulated signal $Vpw_{9c}$ which is symmetrically modulated on both edges. A signal $Vx_1$ is shown between delays 213 and 214.

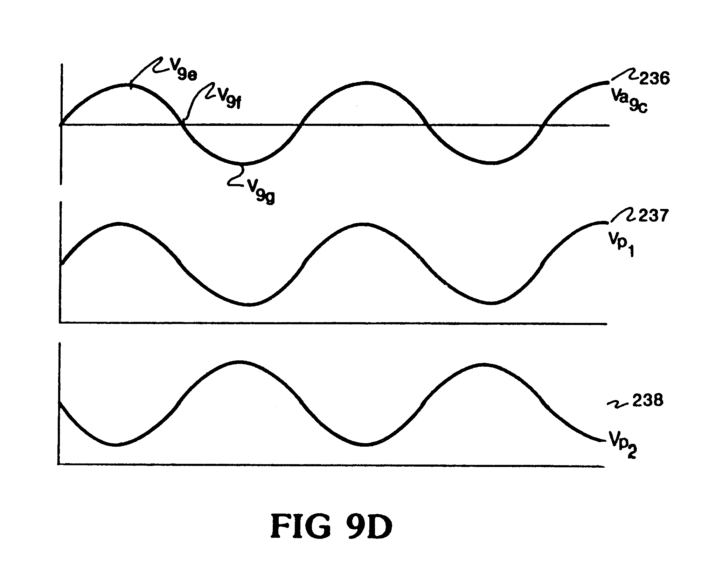

In Figure 9D, a timing diagram for the circuit inputs is given. A waveform 236 represents analog signal $Va_{9c}$. A waveform 237 represents first output signal $Vp_1$. A waveform 238 represents second output signal $Vp_2$. Voltage values $V_{9e}$, $V_{9f}$ and $V_{9g}$ of signal $Va_{9c}$ are shown.

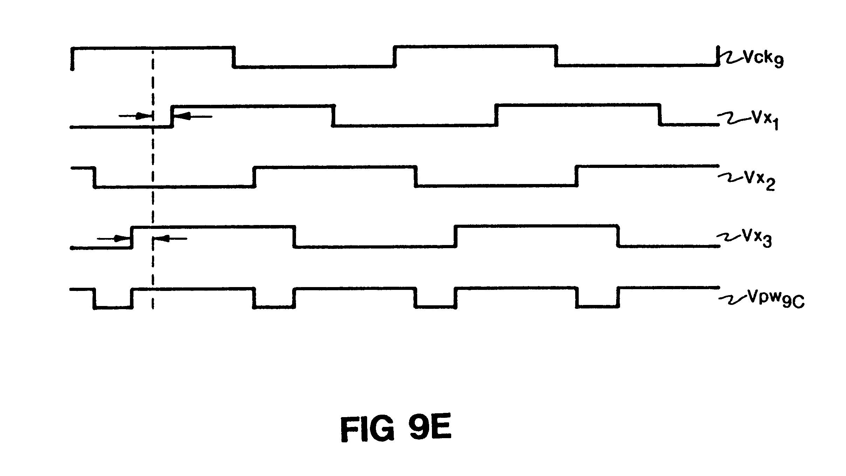

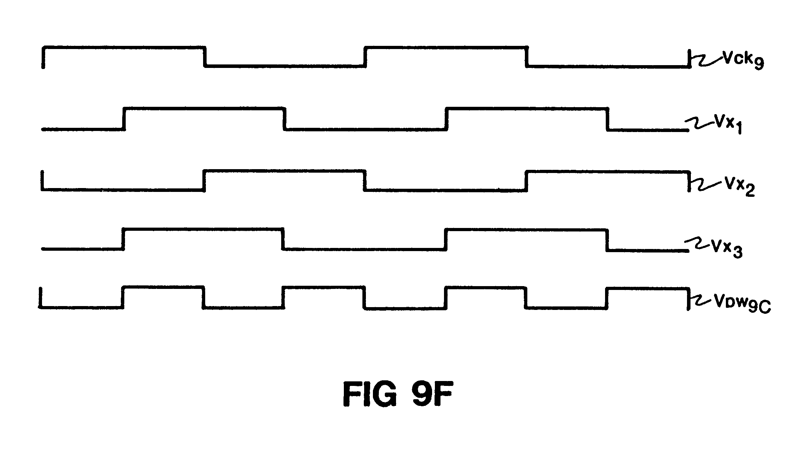

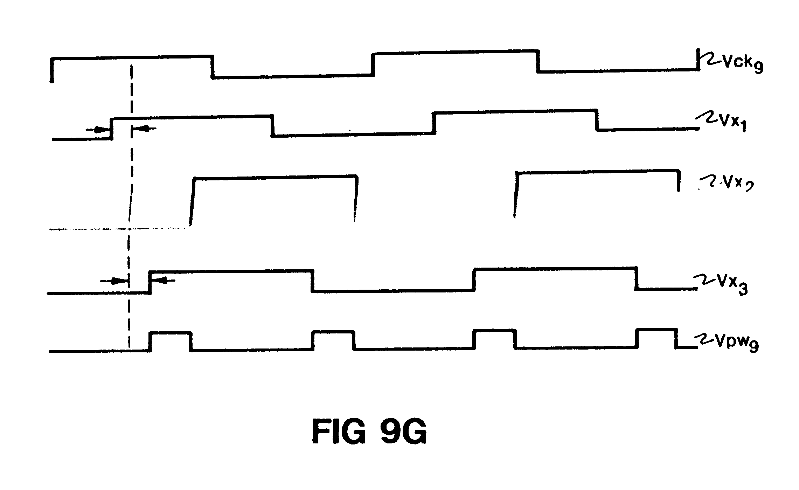

Figure 9E shows a timing diagram of signals $Vck_9$, $Vx_1$, $Vx_2$, $Vx_3$, and $Vpw_{9c}$ when analog signal $Va_{9c}$ is at voltage value $V_{9e}$. Figure 9F shows a timing diagram of signals $Vck_9$, $Vx_1$, $Vx_2$, $Vx_3$, and $Vpw_{9c}$ when analog signal $Va_{9c}$ is at voltage value $V_{9f}$. Figure 9G shows a timing diagram of signals $Vck_9$, $Vx_1$, $Vx_2$, $Vx_3$, and $Vpw_{9c}$ when analog signal $Va_{9c}$ is at voltage value $V_{9g}$.

The circuit shown in Figure 9C has several performance improvements over the circuit in Figure 9A. For instance, in the circuit of Figure 9C, both the rising edge and the falling edge of pulses may be affected by changes in signal $Va_{9c}$. In the circuit in Figure 9A, varying the time delay of delay 204 results only in changing the falling edge of pulses in waveform 219. Because it varies both falling and rising edges of each pulse, the circuit in Figure 9C can have the same dynamic range as the circuit in Figure 9A when delay 212 and delay 213 have only half as many saturating elements as delay 204. This helps to cancel modulation nonlinearities which may appear in signal $Va_{9c}$ as a result of being propagated through delays 212 and 213.

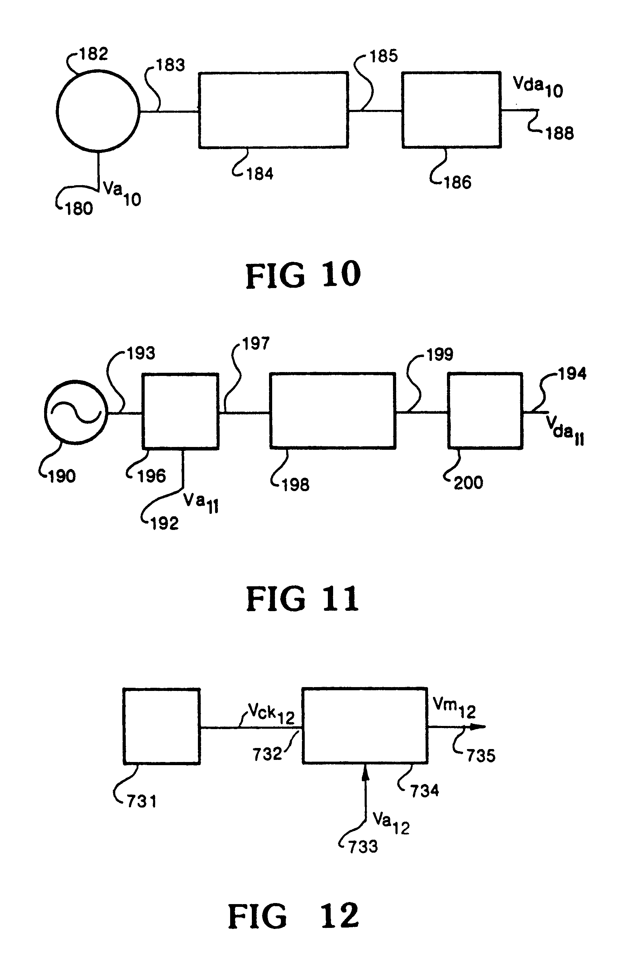

Figure 10 is a simplified block diagram of a delay circuit employing frequency modulation. An analog signal $Va_{10}$ is applied to an input 180 of a voltage controlled oscillator 182. An output 183 of voltage controlled oscillator 182 is coupled to a delay 184, typically comprising cascaded inverters, as discussed above. An output 185 of delay 184 is coupled to an FM detector 186. A delayed analog signal $Vda_{10}$ thus appears on an output 188 of FM detector 186.

Figure 11 is a simplified block diagram of a delay circuit employing phase modulation. An analog signal $Va_{11}$ is applied to an input 192 of a phase modulator 196. Coupled to a second input 193 of phase modulator 196 is a constant frequency signal generator 190. An output 197 of phase modulator 196 is coupled to a delay line 198. Delay line 198 typically comprises cascaded inverters, as discussed above. An output 199 of delay 198 is coupled to a phase detector 200. A delayed analog signal $Vda_{11}$ appears on an output 194 of phase detector 200.

Figure 12 shows a block diagram of a circuit which can be used for either frequency modulation or phase shift modulation of a signal $Va_{12}$. Clock pulses $Vck_{12}$ are coupled to an input 732 of a delay circuit 734, by a clock generator 731. Typically delay 734 comprises cascaded inverters as described above. Analog signal $Va_{12}$ is coupled to an input 733 of delay 734. By the methods described above, signal $Va_{12}$ varies propagation delay through delay 734. Therefore, a frequency modulated or phase shift modulated signal $Vm_{12}$ appears on an output 735 of delay 734.

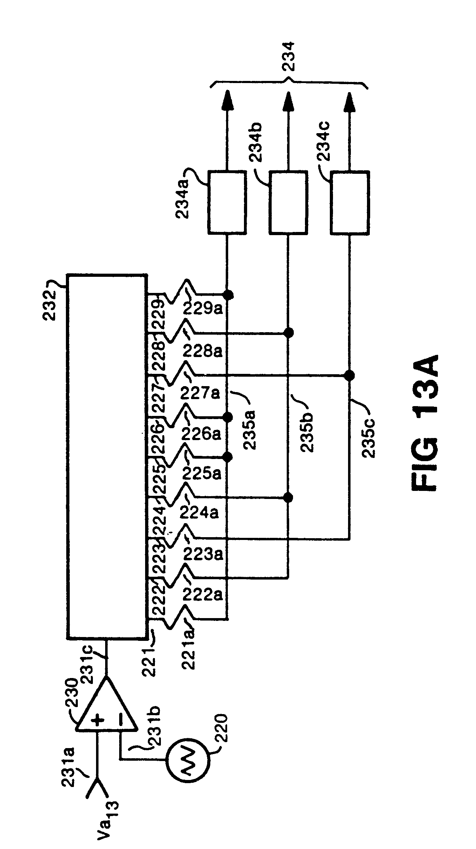

Figure 13A shows a transversal filter embodying the present invention (For a general discussion of transversal filters and their properties see Transversal Filters, by Heinz E. Kallmann, Proceedings of the I.R.E., July, 1940). An analog signal $Va_{13}$ is applied to a first input 231a of a modulator, for instance a comparator 230. Coupled to a second input 231b of comparator 230 is a carrier wave generator 220. An output 231c of comparator 240 is coupled to a delay 232, typically comprising cascaded inverters as discussed above.

A series of outputs or "taps" 221, 222, 223, 224, 225, 226, 227, 228, and 229 of delay 232 are combined at summing nodes 235a, 235b, and 235c. Each tap 221-229 has associated with it a resistance 221a-229a as shown. Values for resistances 221a-229a are selected to weight signals on taps 221-229 so that when linearly combined at nodes 235a, 235b, and 235c they will have desired transversal filter characteristics. Low pass filters 234a, 234b, and 234c remove modulation carrier waves from linear combined signals at summing nodes 235a, 235b, and 235c and produce low pass filter outputs 234. As shown in Figure 13A, use of cascaded delay elements in the implementation of transversal filters allows generation of multiple transversal filter characteristic with a minimum number of circuit elements.

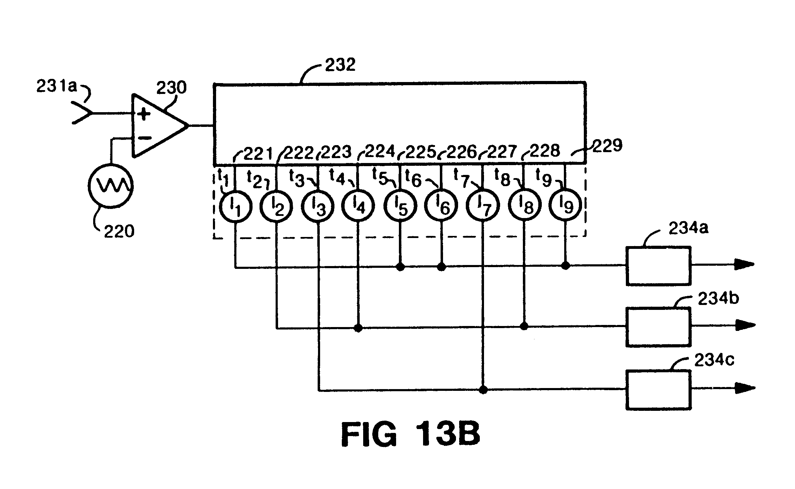

Figure 13B shows the transversal filter of Figure 13A where resistances 221a-229a are replaced by current sources $I_1$-$I_9$. Signals $t_1$-$t_9$ act as control input signals to current sources $I_1$-$I_9$. For instance, when $t_1$ is at logic 1, $I_1$ is "on" and when $t_1$ is at logic 0, $I_1$ is "off". Use of current sources $I_1$-$I_9$ allows for more complete integration on the transversal filter on an integrated circuit.

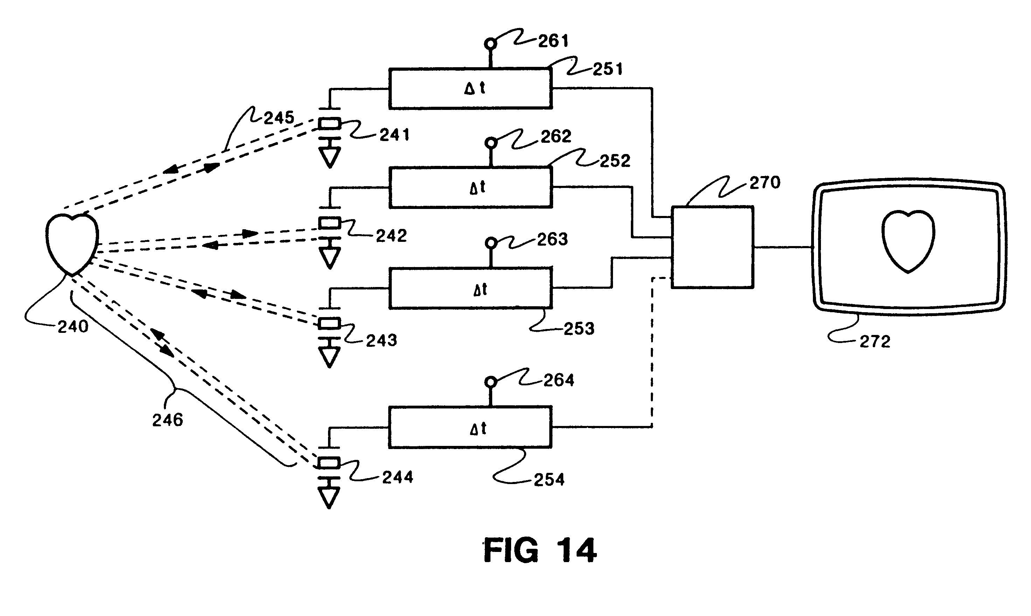

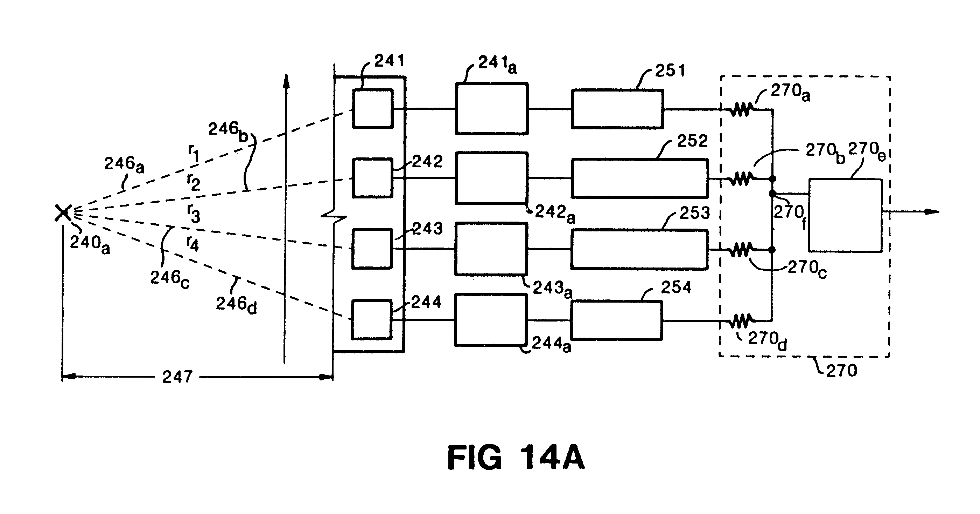

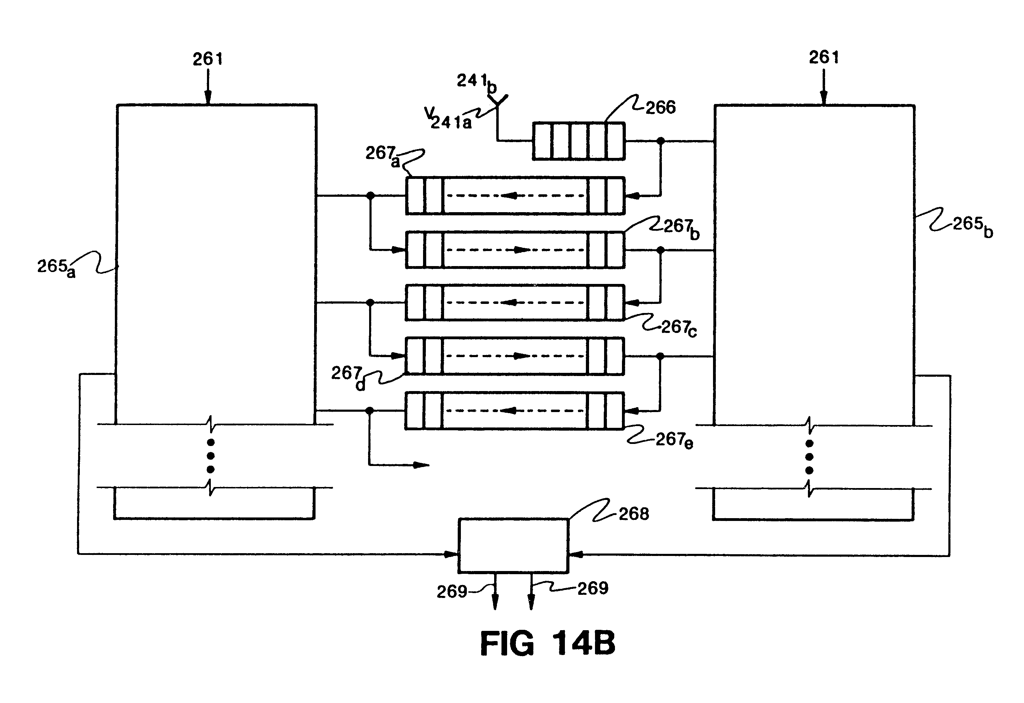

Figure 14 is a block diagram of an acoustic imaging system embodying the present invention (For a general discussion of acoustic imaging see Ultrasound Imaging: An Overview, by H. Edward Karrer and Arthur M. Dickey, Hewlett-Packard Journal, October 1983). A series of transducers 241, 242, 243, and 244 send outgoing ultrasound pulses 245 toward a body organ 240. Body organ 240 reflects, absorbs and/or scatters outgoing ultrasound pulses 245. Transducers 241-244 then receive incoming ultrasound pulses 246 which are the remnants of reflected and scattered outgoing ultrasound pulses 245. Transducers 241-244 transform incoming ultrasound pulses 246 to electrical signals which are coupled through receivers and modulators (shown in Figure 14A) to a series of time delays 251, 252, 253, and 254. Each time delay 251- 254 has a time delay control 261, 262, 263 and 264, associated with it. Time delay controls 261-264 can be used to vary the delay associated with each time delay 251-254. Time delays 251-254 may be circuits similar to the circuit of Figure 5 discussed above. By varying each time delay 251-254 ultrasound pulses 246 can be combined by a summing circuit 270 to produce an image 272 of body organ 240.

Figure 14A is a block diagram of a portion of the acoustic imaging system shown in Figure 14. Receivers 241a - 244a shown coupled between transducers 241 - 244 and time delays 251 - 254 include modulating circuits which output binary signals. Receivers 241a - 244a pulse width modulate signals before coupling them to time delays 251 - 254. A focus point 240a on body organ 240 is a depth 247 within a human body. Incoming reflected ultrasound pulse paths 246a - 246d are of varying lengths. The length of each time delay 251 - 254 is selected so that incoming ultrasound pulses traveling from focus point 240a to summing circuit 270 have identical delay times, acoustic plus electrical, regardless of which ultrasound pulse path 246a - 246d it travels. As shown summing circuit 270 may consist of resistances 270a-270d and a low pass filter 270e. Thus pulsewidth modulated signals emerging from delay lines 251-254 are linearly combined in a resistive network (i.e. resistors 270a-270d) at a node 270f before being passed through common low pass filter 270e for demodulation.

Figure 14B shows in more detail a possible design for delay 251. Delay time control 261 is input to tap selection networks 265a and 265b. An input 241b carrying a pulse width modulated signal $V_{241a}$ from receiver 241a is coupled through delay section 266 to delay sections 267a - 267e. Although only 267a - 267e are shown, typically many more delay sections may be coupled in the manner shown in Figure 14B. In this embodiment, each delay section 267a - 267e includes 63 inverters and signals are delayed 62.5ns by each delay section. Each delay section 267a - 267e has an output coupled to a first of tap selection networks 265a and 265b, and an input coupled to the other of tap selection networks 265a and 265b. Delay time control 261 directs tap selection networks 265a and 265b to select one output from delay sections 267a -267e to be coupled to a combiner 268 and coupled to summing circuit 270, shown in Figure 14A, through a combiner output 269. The delay section output selected by tap selection networks 265a and 265b determines length of delay through delay 251. Delay through delay 251 can thus be selected by control 261 in 62.5 nanosecond increments. If smaller increments are desired, shorter delay sections with fewer inverters and/or shorter propagation time through each inverter can be designed.

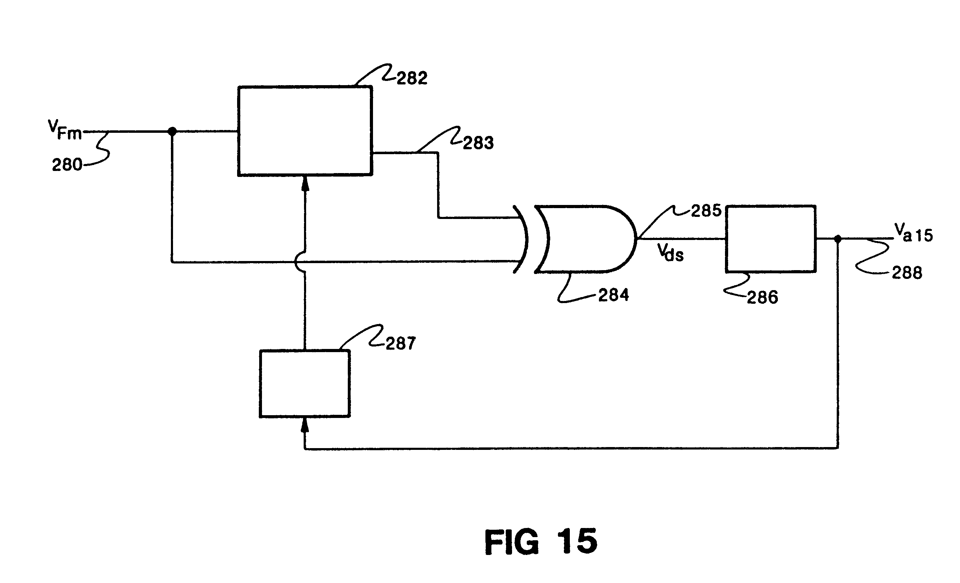

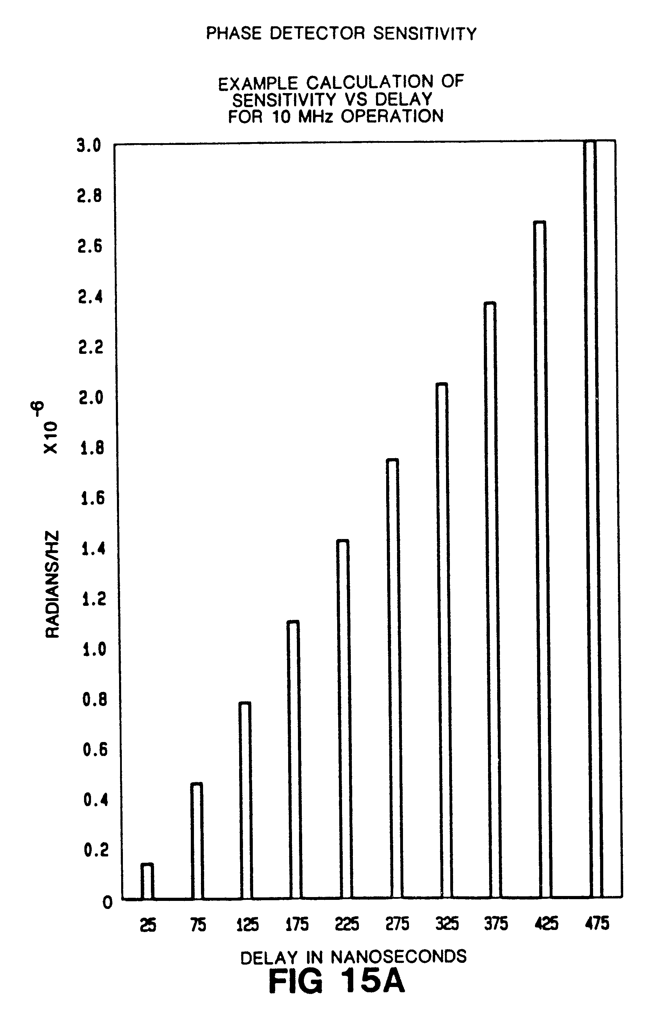

Figure 15 is a simplified block diagram of an FM detector embodying the present invention (For a general discussion of the use of delay lines in FM detectors, see Synchronous Delay-Line Detector Provides Wideband Performance, by Joseph F. Lutz, Microwaves & RF, November, 1982). A limited FM signal Yfm, for instance an amplitude limited FM signal with a carrier wave frequency of 10.7 MHz, is coupled to a delay 282, typically cascaded inverters as described above. Delay 282 is typically selected to perform a $(n+1)90°$ phase shift at the carrier wave frequency (10.7 MHz). An output 283 from delay 282 and the limited FM signal Vfm are coupled through a Boolean Exclusive Or (XOR) gate 284 to a low pass filter 286. XOR gate 284 could be replaced by other logic gates, for instance, an "AND" gate, or an "OR" gate or by various types of "FLIP- FLOPS", which have an output signal with a duty cycle which varies according to the relative phase between two input signals. A digital signal Vds at an output 285 of XOR gate 284 is essentially a pulse width modulated signal. Low pass filter 286 removes the carrier wave from pulse width modulated signal Vds and produces a demodulated analog signal $Va_{15}$. A low pass filter 287 with a cutoff frequency below the FM signal range may also be added to provide enhanced stability. Low pass filter 287 can be electrically coupled to delay 282 providing feedback to assure delay 282 continues to perform a $(n+1)90°$ phase shift at the carrier wave frequency.

In order to perform a 90° phase shift or an odd multiple of a 90° phase shift (e.g. 90°, 450°, or 810°), delay 282 must time delay limited FM signal Vfm for the 90° phase shift or for one of its odd multiples. As the graph of Figure 15A demonstrates, increasing the time delay to a higher multiple of a 90° phase shift increases the sensitivity of the FM detector. This effect is analogous to the increase in sensitivity with increasing Q (where Q is the figure of merit of a resonance circuit and is the ratio of reactance over resistance) for a conventional FM detector constructed from tuned circuits. The graph of Figure 15A shows the calculation of sensitivity verses delay, where the carrier wave frequency is 10 MHz. Sensitivity in radians/hertz x

$10_{-6}$ is on the vertical axis, while length of delay in nanoseconds is on the horizontal axis.

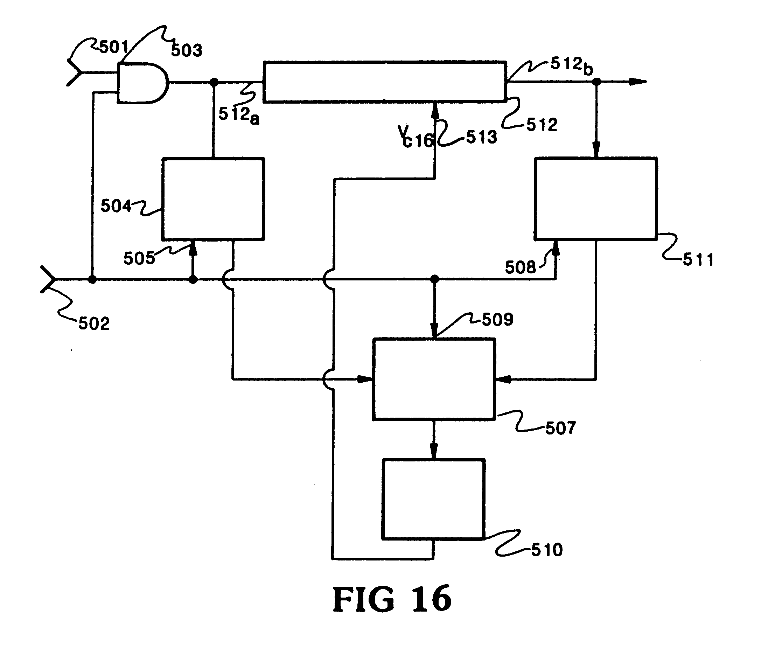

Figure 16 is a block diagram of a circuit which calibrates a delay element to a fixed duration. Such calibration of delay elements is important for many applications, for instance, in the design of delay 251 shown in Figure 14B.

In Figure 16, a delay line 512, typically comprising cascaded inverters as discussed above, has a control voltage input 513. A voltage $Vc_{16}$ on input 513 is used to vary the duration of signal delay through delay line 512. A counter 504 is coupled to an input 512a of delay line 512. A counter 511 is coupled to an output 512b of delay line 512. Counters 504 and 511 are selected to provide signals which have a period greater than the maximum possible delay through delay line 512.

Outputs from counters 504 and 511 are coupled to a timing element 507. Timing element 507 is typically a comparator or a flip-flop. Timing element 507 serves to align the output from counter 504 and the output from counter 511 by comparing the outputs and coupling a signal through a filter 510 to produce signal $Vc_{16}$ on input 513 of delay line 512. Signal $Vc_{16}$ acts as feedback to delay line 513 calibrating the duration of propagation delay through delay line 512. A reset input 502 is coupled to counter 504 through a reset input 505, to counter 511 through a reset input 508, and to delay 512 through a Boolean logic "AND" gate 503.

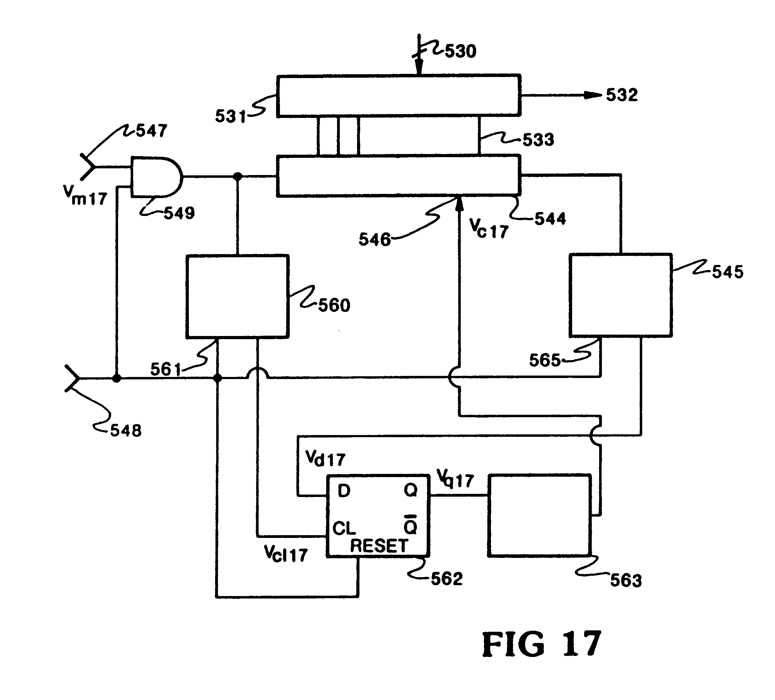

In Figure 17 an embodiment of the circuit in Figure 16 is shown which can be used to calibrate delays 267a - 267e of Figure 14B. A 1 microsecond delay line 544 corresponds to delay line 512 of Figure 16. Delay line 544 is coupled to a tap selection network 531 through a series of tap lines 533. Select lines 530 select which tap of series of tap lines 533 is coupled to delay output 532. When different tap lines are selected propagation delay from a system input 547 and to output 532 vary accordingly.

Divide-by-64 counters 560 and 545 respectively correspond to counters 504 and 511. A Delay (D) flip-flop 562 corresponds to timing element 507. A low pass filter 563 corresponds to filter 510. Reset inputs 548, 561, 562 and 565 correspond to reset inputs 502, 505, 509 and 508 respectively. A Boolean logic "AND" gate 549 corresponds to gate 503.

A pulse modulated 32 megahertz (MHz) signal $Vm_{17}$ is coupled to input 547 and through AND gate 549 to counter 560 and through delay line 544 to counter 545. Divide-by-64 counter 560 couples a .5 MHz signal $Vcl_{17}$ to a clock input CL of D flip-flop 562. Divide-by-64 counter 545 through "NOT" gate 564 couples a .5 MHz signal $Vd_{17}$ to a D input of D flip-flop 562. When delay line 544 is calibrated at 1 microsecond, $Vd_{17}$ and $Vcl_{17}$ will be in phase.

A signal $Vq_{17}$ on a Q output of D flip-flop 562 will have a duty cycle which is used to generate a control feedback signal $Vc_{17}$.

Signal $Vq_{17}$ is coupled through low pass filter 563 to a control input 546 of delay line 544 and becomes control feedback signal $Vc_{17}$. If delay line 544 has a propagation delay longer than 1 microsecond, the duty cycle of signal $Vq_{17}$ increases, thereby increasing $Vc_{17}$ and decreasing propagation delay through delay line 544. If delay line 544 has a propagation delay shorter than 1 microsecond, the duty cycle of signal $Vq_{17}$ decreases, thereby decreasing $Vc_{17}$ and increasing propagation delay through delay line 544. Thus propagation delay through delay line is calibrated at one microsecond.

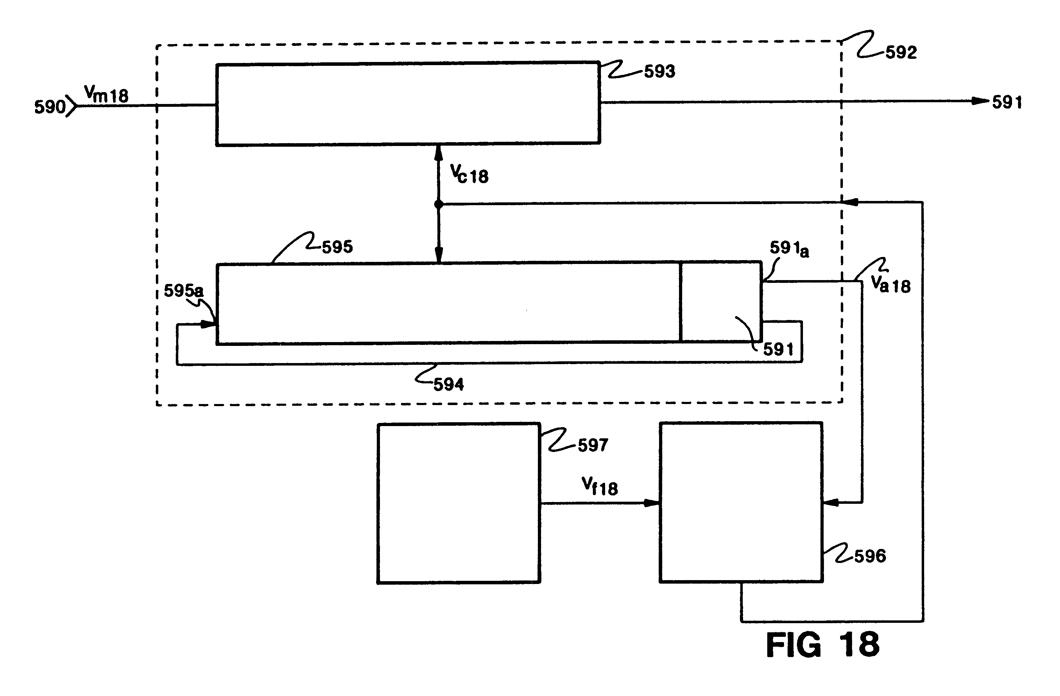

Figure 18 shows a circuit which may be used to calibrate propagation delay time from an input 590 of a delay line 593 to an output 591 of delay line 593 when an input signal $Vm_{18}$ on input 590 is intermittant or not referenced to a calibration standard. Calibration is done by utilizing tracking properties inherent within integrated circuits. A calibration delay line 595 resides on an integrated circuit 592 near delay line 593. Delay line 595 is coupled to a buffer 591 and a wire 594 which serve to electrically couple an output 591a of buffer 591 to an input 595a of delay line 595. If delay line 595 comprises an odd number of inverters, then a signal $Vo_{18}$ at output 591a will oscillate at a frequency determined by the duration of signal delay through delay line 595.

A phase locked loop circuit 596 forces signal $Vo_{18}$ to oscillate at the same frequency as a signal $Vf_{18}$ generated by an external frequency source 597 by comparing the frequencies of the signals and producing a control signal $Vc_{18}$ which varies propagation delay through delay line 595 until signal $Vo_{18}$ oscillates at the same frequency as signal $Vf_{18}$. External frequency source 597 can therefore be used to select a particular frequency for signal $Vf_{18}$ and thus determine propagation delay through delay line 595. Furthermore, $Vc_{18}$ also varies signal propagation delay time through delay line 593. Because of the tracking properties of integrated circuits, determination of signal propagation delay through delay line 595 allows determination of signal propagation through delay line 593. Therefore delay line 593 may be calibrated by signal $Vf_{18}$.

## Claims

1. A delay circuit for deriving from an analog input signal an analog output signal having a predetermined delay relative to the analog input signal, the circuit comprising:
   - a modulator for producing a pulse width-, or frequency-, or phase modulated signal in response to the analog input signal,
   - a delay element (124; 512) coupled to the modulator for delaying the modulated signal, and
   - a demodulator for demodulating the delayed modulated signal, thus providing the delayed analog output signal,
   - the delay element comprising a plurality of cascaded inverters, characterized in that each inverter (64, 66, 68, 70) of the delay element (124; 512) comprises:
   - a voltage source (Vdd),
   - an adjustable resistance element (74, 76, 78, 80) coupled to the voltage source (Vdd) for providing a resistance to current flow, and
   - a field effect transistor as a saturating element coupled to the resistance element at one side and to ground at the other side and with its gate terminal to an output of the preceding inverter, and
   - that for calibrating the delay element to a predetermined delay time, a control circuit (504, 511, 507, 510) is provided comprising a first counter (504) coupled to an input (512a) of the delay element (512) and a second counter (511) coupled to an output (512b) of the delay element the counters (504, 511) providing signals which have a period greater than the maximum delay through the delay element (512), and a timing element (507) for comparing in phase the output signals of the counters (504, 511) and supplying a control signal to the adjustable resistance elements of the delay element.

2. The delay circuit according to claim 1, characterized in that
   - the modulator is a pulse width modulator (162) producing a pulse width modulated signal ($V_{p8}$) having only two logical states, with the pulse width corresponding to the amplitude of the analog input signal ($Va_8$), and
   - the pulse width modulator (162) comprises a comparator (630) for comparing the analog input signal ($Va_8$) with a carrier signal ($Vtr_8$) having a predetermined triangular shape to produce a pulse width modulated signal ($Vp_8$).

3. The delay circuit according to claim 1, characterized in that the pulse width modulator (162) comprises:
   - a circuit for adding the analog input signal ($Va_8$) to a carrier signal ($Vtr_8$) having

a predetermined triangular shape to produce a sum signal (Vadd$_8$), and
- a comparator (660) for comparing the sum signal with a fixed reference signal to produce a pulse width modulated signal (Vp8).

4. The delay circuit according to claim 1, characterized in that
each inverter in the plurality of cascaded inverters comprises:
- a control means (74; 102) acting as said adjustable resistance element, coupled with a first node to the voltage source (Vdd), with its second node to the field effect transistor and with its third node (62; 118) to the control circuit, wherein a signal (Vc$_4$; Vc$_5$) placed on the third node acts to vary delay through the inverter;
- a first depletion-type MOSFET (621) including a drain node coupled to the second node of the control means, a gate node (627) coupled to a prior inverter and a source node (625) coupled to a subsequent inverter, and
- a first enhancement-type MOSFET (623) including a drain node coupled to the source node (625) of the first depletion-type MOSFET,
a source node coupled to ground and a gate node (629) coupled to the prior inverter and to a gate node of the depletion-type MOSFET (622) in the subsequent inverter (Fig. 5B).

5. The delay circuit according to claim 4, characterized in that
the control means comprises a second depletion-type MOSFET (102), its drain being the first node, its source being the second node and its gate being the third node (118) of the control means (Fig. 5C).

6. The delay circuit according to claim 5, characterized in that
the gate node of the second depletion-type MOSFET is - coupled to a gate node of the control means in the preceding inverter and to a gate node of a control means in the subsequent inverter.

7. A delay circuit according to claim 4, characterized in that the control means in each inverter comprises:
a second depletion-type MOSFET (351) having a drain node as the first node, a source node and a gate node as the third node and

a third depletion-type MOSFET (353) having a drain node coupled to the source node of the second depletion-type MOSFET (351), a source node which is the second node and a gate node coupled to the gate node of the second depletion-type MOSFET (351).

8. The delay circuit according to claim 7, characterized in that
the third node is coupled to a third node of the control means in the preceding inverter and is coupled to a third node of a control means in the subsequent inverter.

9. The delay circuit according to claim 4, characterized in that
the control means comprises:
a second depletion-type MOSFET (381) having a drain node which is the first node, a source node which is the second node and a gate node which is the third node and a second enhancement-type MOSFET (383) having a drain node coupled to the drain node of the second depletion-type MOSFET, a source node coupled to the source node of the second depletion-type MOSFET and a gate node coupled to the gate node of the second depletion-type MOSFET (Fig. 5E).

10. The delay circuit according to claim 9, characterized in that
the third node is coupled to a third node of the control means in the preceding inverter and to a third node of the control means in the subsequent inverter.

11. Use of the delay circuit according to any of the claims 1 through 10 in an ultrasound imaging system comprising a plurality of transducing elements (241 to 244) for receiving ultrasound signals reflected from an object under examination and for converting the ultrasound signals to electrical signals,
wherein for deriving an image signal corresponding to ultrasound signals originating from a focus point (240a) within the object under examination each transducing element (241) of a predetermined group of transducing elements (241 to 244) has an associated adjustable delay circuit (251), the corresponding delay times being adjusted such that the different propagation times of the ultrasound signals from the focus point to the various transducing elements are compensated, and wherein a summing circuit (270) is provided for combining the output signals of the delay circuits (251 to 254) to produce the image signal.

**12.** Use of the delay circuit as in claim 11, wherein the input of the summing circuit (270A to 270D) is coupled to the outputs of the delay elements (251 to 254) associated with the transducers (241 to 244), and wherein the output of the summing circuit is coupled to a common demodulator (270E).

**13.** Use of the delay circuit according to claims 11 or 12, wherein

each delay circuit in the adjustable delay circuits additionally comprises:

an input means (241b, 266) for coupling the signal to the plurality of cascaded inverters, and

an output means (268) for coupling the signal to a subsequent circuit, wherein the control circuit comprises:

    a plurality of taps at intervals of delay along the plurality of cascaded inverters, and

    a switching means (265a, 265b) coupled to the plurality of taps and to the output means for selecting a tap from the plurality of taps to be coupled to the output means.

**14.** Use of the delay circuit according to claim 13, wherein the plurality of taps are provided at equal intervals of delay time.

## Revendications

**1.** Un circuit de retard pour dériver d'un signal analogique d'entrée un signal analogique de sortie ayant un retard prédéterminé par rapport au signal analogique d'entrée, le circuit comprenant :

- un modulateur pour produire un signal modulé en largeur, ou en fréquence, ou en phase d'impulsions en réponse à un signal analogique d'entrée,
- un élément de retard (124 ; 512) relié au modulateur pour retarder le signal modulé, et
- un démodulateur pour démoduler le signal modulé retardé, en produisant ainsi le signal analogique de sortie retardé,
- l'élément de retard comprenant plusieurs inverseurs connectés en cascade,
- caractérisé en ce que chaque inverseur (64, 66, 68, 70 ) de l'élément de retard (124 ; 512) comprend:
- une source de tension (Vdd),
- un élément formant résistance réglable (74, 76, 78, 80) relié à la source de tension (Vdd) pour opposer une résistance à l'écoulement du courant, et
- un transistor à effet de champ servant d'élément de saturation relié à l'élément formant résistance d'un côté et à la masse de l'autre côté et dont sa borne de grille est reliée à une sortie de l'inverseur précédent, et

- en ce que, pour l'étalonnage de l'élément de retard à un temps de retard prédéterminé, il est prévu un circuit de commande (504, 511, 507, 510 ) comprenant un premier compteur (504) relié à une entrée (512a) de l'élément de retard (512) et un second compteur (511) relié à une sortie (512b) de l'élément de retard, les compteurs (504, 511) produisant des signaux ayant une période plus grande que le retard maximal dans l'élément de retard (512), et un élément de synchronisation (507) pour comparer en phase les signaux de sortie des compteurs (504, 511) et pour appliquer un signal de commande aux éléments formant résistances réglables de l'élément de retard.

**2.** Le circuit de retard selon la revendication 1, caractérisé en ce que :
- le modulateur est un modulateur de largeur d'impulsions (162) produisant un signal modulé en largeur d'impulsions (Vp8) comportant seulement deux états logiques, la largeur d'impulsions correspondant à l'amplitude du signal analogique d'entrée (Va8), et
- le modulateur de largeur d'impulsions (162) comprend un comparateur (630) pour comparer le signal analogique d'entrée (Va8) avec un signal de porteuse (Vtr8) ayant une forme triangulaire prédéterminée pour produire un signal modulé en largeur d'impulsions (VP8).

**3.** Le circuit de retard selon la revendication 1, caractérisé en ce que le modulateur de largeur d'impulsions (162) comprend :
- un circuit pour additionner le signal analogique d'entrée (Va8) à un signal de porteuse (Vtr8) ayant une forme triangulaire prédéterminée pour produire un signal de somme (Vadd8), et
- un comparateur (660) pour comparer le signal de somme avec un signal de référence fixé pour produire un signal modulé en largeur d'impulsions (Vp 8).

**4.** Le circuit de retard selon la revendication 1, caractérisé en ce que chaque inverseur de l'ensemble d'inverseurs connectés en cascade comprend :
- un moyen de commande (74 ; 102) agissant comme ledit élément formant résistance réglable, relié par un premier noeud avec la source de tension (Vdd), par son second noeud avec le transistor à effet de champ et par son troisième noeud (62 : 118) avec le circuit de commande, un signal (Vc4 ; Vc5) appliqué au troisième noeud agissant pour faire varier le retard dans l'inverseur ;
- un premier transistor MOSFET (621) de type-appauvrissement comprenant un noeud de drain qui est relié au second noeud du moyen de commande, un noeud de grille (627) qui est relié à un inverseur précédent et un noeud de source (625) qui est relié à un inverseur suivant, et
- un premier transistor MOSFET (623) de type-enrichissement, comprenant un noeud de drain relié au noeud de source (625) du premier transistor MOFSET de type-appauvrissement, un noeud de source relié à la masse et un noeud de grille (629) relié à l'inverseur précédent ainsi qu'à un noeud de grille du transistor MOSFET (622) de type-appauvrissement dans l'inverseur suivant ( Figure 5B).

5. Le circuit de retard selon la revendication 4, caractérisé en ce que le moyen de commande comprend un second transistor MOSFET (102) du type-appauvrissement, son drain étant le premier noeud, sa source étant le second noeud et sa grille étant le troisième noeud (118) du moyen de commande ( Figure 5C).

6. Le circuit de retard selon la revendication 5, caractérisé en ce que le noeud de grille du second transistor MOSFET de type-appauvrissement est relié à un noeud de grille du moyen de commande dans l'inverseur précédent et à un noeud de grille d'un moyen de commande dans l'inverseur suivant.

7. Un circuit de retard selon la revendication 4, caractérisé en ce que le moyen de commande dans chaque inverseur comprend :
- un second transistor MOSFET (351) de type-appauvrissement comportant un noeud de drain comme le premier noeud, un noeud de source et un noeud de grille comme le troisième noeud et
- un troisième transistor MOSFET (353) de type-appauvrissement comportant un noeud de drain relié au noeud de source du second transistor MOSFET (351) de type

- appauvrissement, un noeud de source qui constitue le second noeud et un noeud de grille relié au noeud de grille du second transistor MOSFET (351) de type-appauvrissement.

8. Le circuit de retard selon la revendication 7, caractérisé en ce que le troisième noeud est relié au troisième noeud du moyen de commande dans l'inverseur précédent et est relié à un troisième noeud d'un moyen de commande dans l'inverseur suivant.

9. Le circuit de retard selon la revendication 4, caractérisé en ce que le moyen de commande comprend:
- un second transistor MOSFET (381) de type-appauvrissement comportant un noeud de drain qui constitue le premier noeud, un noeud de source qui constitue le second noeud et un noeud de grille qui constitue le troisième noeud, et
- un second transistor MOSFET (383) de type-enrichissement comportant un noeud de drain relié au noeud de drain du second transistor de type-appauvrissement, un noeud de source relié au noeud de source du second transistor MOSFET de type-appauvrissement et un noeud de grille relié au noeud de grille du second transistor MOSFET de type-appauvrissement (Figure 5E).

10. Le circuit de retard selon la revendication 9, caractérisé en ce que le troisième noeud est relié à un troisième noeud du moyen de commande dans l'inverseur précédent et à un troisième noeud du moyen de commande dans l'inverseur suivant.

11. Utilisation du circuit de retard selon une quelconque des revendications 1 à 10 dans un système de formation d'image ultrasonique comprenant un ensemble d'éléments transducteurs (241 à 244) pour recevoir des signaux ultrasoniques réfléchis par un objet en cours d'examen et pour convertir les signaux ultrasoniques en signaux électriques,
- où pour dériver un signal d'image correspondant aux signaux ultrasoniques provenant d'un point focal (240a) à l'intérieur de l'objet en cours d'examen, chaque élément transducteur (241) d'un groupe prédéterminé d'éléments transducteurs (241 à 244) comporte un circuit de retard réglable associé (251), les temps de retard correspondants étant ajustés de telle sorte que les différents temps de propagation des signaux ultrasoniques depuis le point focal jusqu'aux différents éléments transducteurs soient compensés, et

- où il est prévu un circuit de sommation (270) pour combiner les signaux de sortie des circuits de retard (251 à 254) de façon à produire le signal d'image.

12. Utilisation du circuit de retard selon la revendication 11,
- où l'entrée d'un circuit de sommation (270A à 270D) est reliée aux sorties des éléments de retard (251 à 254) associés aux transducteurs (241 à 244), et
- où la sortie du circuit de sommation est reliée à un démodulateur commun (270E).

13. Utilisation du circuit de retard selon les revendications 11 ou 12, dans lequel :
- chaque circuit de retard de l'ensemble de circuits de retard réglables comprend additionnellement :
- un moyen d'entrée (241b, 270) pour appliquer le signal aux différents inverseurs en cascade, et
- un moyen de sortie (268) pour appliquer le signal à un circuit suivant, le circuit de commande comprenant:
  - plusieurs prises correspondant à des intervalles de retard et situées le long des inverseurs en cascade de l'ensemble, et
  - un moyen de commutation (265a, 265b) relié aux différentes prises et au moyen de sortie pour sélectionner une prise parmi l'ensemble de prises pour la relier au moyen de sortie.

14. Utilisation du circuit de retard selon la revendication 13, où les prises de l'ensemble sont activées à des intervalles de temps de retard qui sont égaux.

**Patentansprüche**

1. Verzögerungsschaltung zur Erzeugung eines analogen Ausgangssignals aus einem analogen Eingangssignal, welches Ausgangssignal gegenüber dem Eingangssignal eine vorgegebene Verzögerung hat, wobei die Schaltung aufweist:
- einen Modulator, der ein impulsbreitenmoduliertes oder ein frequenzmoduliertes oder phasenmoduliertes Signal abhängig vom analogen Eingangssignal erzeugt,
- ein mit dem Modulator verbundenes Verzögerungsglied (124 bis 512) zur Verzögerung des modulierten Signals, und
- einen Demodulator, der das verzögerte, modulierte Signal demoduliert und dadurch das verzögerte analoge Ausgangssignal erzeugt,
- wobei das Verzögerungsglied mehrere in Kaskade geschaltete Invertierschaltungen aufweist,

  dadurch gekennzeichnet, daß jede Invertierschaltung (64, 66, 68, 70) des Verzögerungsglieds (124 bis 512) aufweist:
- eine Spannungsquelle (Vdd),
- ein einstellbares Widerstandsglied (74, 76, 78, 80), das mit der Spannungsquelle (Vdd) verbunden ist, um einen Widerstand für den Stromfluß zu bilden, und
- einen Feldeffekttransistor als Sättigungsglied, der an seiner einen Seite mit dem Widerstandsglied, an seiner anderen Seite mit Erde und mit seinem Gateanschluß mit einem Ausgangsanschluß der vorangehenden Invertierschaltung verbunden ist, und
- daß zur Eichung des Verzögerungsglieds auf eine vorgegebene Verzögerungszeit eine Steuerschaltung (504, 511, 507, 510) vorgesehen ist, die einen ersten mit einem Eingangsanschluß (512a) des Verzögerungsglieds (512) verbundenen Zähler (504), einen zweiten mit einem Ausgangsanschluß (512d) des Verzögerungsglieds verbundenen Zähler (512), wobei die Zähler (504, 511) Signale erzeugen, deren Periode größer als die größte durch das Verzögerungsglied (512) bewirkte Verzögerung ist, und ein Zeitglied (507) aufweist, welches die Phasenlage der Ausgangssignale der Zähler (504, 511) vergleicht und ein Steuersignal dem einstellbaren Widerstandsglied des Verzögerungsglieds zuführt.

2. Verzögerungsschaltung nach Anspruch 1, dadurch gekennzeichnet, daß
- der Modulator ein Pulsbreitenmodulator (162) ist, der ein pulsbreitenmoduliertes Signal (Vp8) erzeugt, welches lediglich zwei logische Zustände hat und bei dem die Pulsbreite der Amplitude des analogen Eingangssignals (Va8) entspricht, und
- der Pulsbreitenmodulator (162) einen Vergleicher (630) aufweist, der zur Erzeugung eines pulsbreitenmodulierten Signals (Vp8) das analoge Eingangssignal (Va8) mit einem eine vorgegebene Dreieckform aufweisenden Trägersignal (Vtr8) vergleicht.

3. Verzögerungsschaltung nach Anspruch 1,

dadurch gekennzeichnet, daß der Pulsbreitenmodulator (162) aufweist:
- eine Schaltung, die zur Erzeugung eines Summensignals (Vadd8) das analoge Eingangssignal (Va8) mit einem eine vorgegebene Dreieckform aufweisenden Trägersignal (Vtr8) addiert, und
- einen Vergleicher (66), der zur Erzeu-gung eines pulsbreitenmodulierten Si-gnals (Vp8) das Summensignal mit einem festen Bezugssignal vergleicht.

4. Verzögerungsschaltung nach Anspruch 1,

dadurch gekennzeichnet, daß jede Invertierschaltung der Vielzahl der in Kaskadenschal-tung verbundenen Invertierschaltungen auf-weist:
- ein Steuerglied (74; 102), welches als das einstellbare Widerstandsglied wirkt und welches mit einem ersten Knoten mit der Spannungsquelle (Vdd) mit einem zweiten Knoten mit dem Feldeffekttransistor und mit einem dritten Knoten (62; 118) mit der Steuerschaltung verbunden ist, wobei ein auf den dritten Knoten gelegtes Signal (Vc4; Vc5) zur Veränderung der durch die Invertierschaltung bewirkten Verzögerung dient;
- einen ersten MOSFET (621) vom Verarmungstyp, dessen Drainanschluß mit dem zweiten Knoten des Steuerglieds, dessen Gateanschluß (627) mit einer vor-angehenden Invertierschaltung und des-sen Sourceanschluß (625) mit einer nachfolgenden Invertierschaltung verbunden ist, und
- einen ersten MOSFET (623) vom Anreicherungstyp, dessen Drainanschluß mit dem Sourceanschluß (625) des ersten Verarmungs-MOSFET, dessen Sourceanschluß mit Erde und dessen Gateanschluß (629) mit der vorangehenden In-vertierschaltung und mit einem Gatean-schluß des Verarmungs-MOSFET (622) der nachfolgenden Invertierschaltung verbunden sind (Fig. 5B).

5. Verzögerungsschaltung nach Anspruch 4,

dadurch gekennzeichnet, daß das Steuerglied einen zweiten Verarmungs-MOSFET (102) aufweist, dessen Drainanschluß den ersten Knoten, dessen Sourceanschluß den zweiten Knoten und dessen Gateanschluß den dritten Knoten (180) des Steuerglieds bilden (Fig. 5C).

6. Verzögerungsschaltung nach Anspruch 5,

dadurch gekennzeichnet, daß der Gateanschluß des zweiten Verarmungs-MOSFET mit einem Gateanschluß des Steuerglieds in der vorangehenden Invertierschaltung und mit einem Gateanschluß eines Steuerglieds in der nachfolgenden Invertierschaltung verbunden ist.

7. Verzögerungsschaltung nach Anspruch 4,

dadurch gekennzeichnet, daß das Steuerglied in jeder Invertierschaltung aufweist:
- einen zweiten Verarmungs-MOSFET (351), der einen den ersten Knoten bil-denden Drainanschluß, einen Sourcean-schluß und einen den dritten Knoten bildenden Gateanschluß hat, und
- einen dritten Verarmungs-MOSFET (353), dessen Drainanschluß mit dem Sourceanschluß des zweiten Verarmungs-MOSFET (351) verbunden ist, dessen Sourceanschluß den zweiten Knoten bildet und dessen Gateanschluß mit dem Gateanschluß des zweiten Verarmungs-MOSFET (351) verbunden ist.

8. Verzögerungsschaltung nach Anspruch 7,

dadurch gekennzeichnet, daß der dritte Knoten mit einem dritten Knoten des Steuerglieds in der vorangehenden Invertierschaltung und mit einem dritten Knoten eines Steuergliedes in der nachfolgenden Invertierschaltung verbunden ist.

9. Verzögerungsschaltung nach Anspruch 4,

dadurch gekennzeichnet, daß das Steuerglied aufweist:
- einen zweiten Verarmungs-MOSFET (381) der einen den ersten Knoten bil-denden Drainanschluß, einen den zwei-ten Knoten bildenden Sourceanschluß und einen den dritten Knoten bildenden Gateanschluß hat, und
- einen zweiten Anreicherungs-MOSFET (383), dessen Drainanschluß mit dem Drainanschluß des zweiten Verarmungs-MOSFET, dessen Sourceanschluß mit dem Sourceanschluß des zweiten Verarmungs-MOSFET und dessen Gateanschluß mit dem Gateanschluß des zweiten Verarmungs-MOSFET verbunden sind (Fig. 5E).

10. Verzögerungsschaltung nach Anspruch 9,

dadurch gekennzeichnet, daß der dritte Knoten mit einem dritten Knoten des Steuerglieds in der vorangehenden Invertierschaltung und mit einem dritten Knoten des Steuerglieds in der folgenden Invertierschaltung verbunden ist.

11. Verwendung der Verzögerungsschaltung nach einem der Ansprüche 1 bis 10 in einem Ultraschallabbildungssystem, das mehrere Wandlerelemente (241 bis 244) zum Empfang von durch ein zu untersuchendes Objekt reflektierten Ultraschallsignalen und zum Umsetzen dieser Ultraschallsignale in elektrische Signale aufweist, wobei jedes Wandlerelement (241) einer vorgegebenen Gruppe von Wandlerelemente (241 bis 244) für die Erzeugung eines Abbildungssignals, das den von einem Fokuspunkt (240a) in dem zu untersuchenden Objekt stammenden Ultraschallsignalen entspricht, eine zugeordnete einstellbare Verzögerungsschaltung (251) hat, deren entsprechende Verzögerungszeiten so eingestellt sind, daß die unterschiedlichen Laufzeiten der Ultraschallsignale vom Fokuspunkt bis zu den verschiedenen Wandlerelementen kompensiert werden, und wobei eine Summierschaltung (270) zur Verknüpfung der Ausgangssignale der Verzögerungsschaltungen (251 bis 254) zur Erzeugung des Abbildungssignals vorgesehen ist.

12. Verwendung der Verzögerungsschaltung nach Anspruch 11, dadurch gekennzeichnet,

daß der Eingang der Summierschaltung (270A bis 270D) mit den Ausgängen der den Wandlern (241 bis 244) zugehörigen Verzögerungsgliedern (251 bis 254) und der Ausgang der Summierschaltung mit einem gemeinsamen Demodulator (270E) verbunden ist.

13. Verwendung der Verzögerungsschaltung nach Anspruch 11 oder 12,

dadurch gekennzeichnet, daß jede Verzögerungsschaltung der einstellbaren Verzögerungsschaltungen zusätzlich aufweist:
  - ein Eingangsglied (241b, 266), das das Signal mit der Vielzahl der in Kaskade geschalteten Invertierschaltungen verbindet, und
  - ein Ausgangsglied (268) welches das Signal einer nachfolgenden Schaltung zuführt, wobei die Steuerschaltung aufweist:
  - eine Vielzahl von Anzapfungen, die an Verzögerungszeitintervallen längs der Vielzahl der in Kaskade geschalteten Invertierschaltungen vorgesehen sind, und
  - Schaltglieder (265a, 265b), die mit der Vielzahl der Anzapfungen und mit dem Ausgangsglied verbunden sind um eine Anzapfung aus der Vielzahl der Anzapfungen zu deren Verbindung mit dem Ausgangsglied aufzuwählen.

14. Verwendung der Verzögerungsschaltungen nach Anspruch 13, dadurch gekennzeichnet,

daß die Anzapfungen bei jeweils gleichen Verzögerungszeitintervallen vorgesehen sind.

**FIG 1**

Vb₂

**FIG 2**

Vdd

**FIG 3**

EP 0 167 157 B1

**FIG 4**

**FIG 5A**

**FIG 5B**

**FIG 5C**

FIG 5D

FIG 5E

EP 0 167 157 B1

$Va_6$ → [122] → $Vm_6$ [130] → [124] → $Vmd_6$ [131] → [126] → $Vda_6$ → [128]

[120]

$Vc_6$

[123]

## FIG 6

$Vm_6$

## FIG 7

## FIG 8

## FIG 8A

## FIG 8B

**FIG 8C**

EP 0 167 157 B1

**FIG 8D**

**FIG 9A**

**FIG 9B**

**FIG 9C**

26

FIG 9D

Vckg

Vx₁

Vx₂

Vx₃

VpwgC

FIG 9E

FIG 9F

EP 0 167 157 B1

**FIG 9G**

EP 0 167 157 B1

FIG 10

FIG 11

FIG 12

EP 0 167 157 B1

**FIG 13A**

FIG 13B

**FIG 14**

FIG 14A

FIG 14B

**FIG 15**

PHASE DETECTOR SENSITIVITY

EXAMPLE CALCULATION OF
SENSITIVITY VS DELAY
FOR 10 MHz OPERATION

FIG 15A

FIG 16

FIG 17

FIG 18